(19) **Europäisches Patentamt / European Patent Office / Office européen des brevets**

(11) **EP 1 465 338 B1**

(12) **FASCICULE DE BREVET EUROPEEN**

(45) Date de publication et mention
de la délivrance du brevet:
**17.09.2008 Bulletin 2008/38**

(51) Int Cl.:
***G06K 9/62*** (2006.01)

(21) Numéro de dépôt: **04101276.6**

(22) Date de dépôt: **29.03.2004**

(54) **Procédé et dispositif d'identification autodidacte d'un mélange sous-déterminé de sources au quatrième ordre.**

Verfahren und Vorrichtung zur blinden Identifikation vierter Ordnung einer unterbestimmten Quellenmischung

Process and apparatus for fourth-order blind identification of an underdetermined mixture of sources

(84) Etats contractants désignés:
**AT BE BG CH CY CZ DE DK EE ES FI FR GB GR HU IE IT LI LU MC NL PL PT RO SE SI SK TR**

(30) Priorité: **01.04.2003 FR 0304043**

(43) Date de publication de la demande:
**06.10.2004 Bulletin 2004/41**

(73) Titulaire: **Thales**
**92526 Neuilly Sur Seine (FR)**

(72) Inventeurs:
• **FERREOL, Anne**
**94117, ARCUEIL (FR)**
• **ALBERA, Laurent**
**94117, ARCUEIL (FR)**
• **CHEVALIER, Pascal**
**94117, ARCUEIL (FR)**

(74) Mandataire: **Dudouit, Isabelle et al**
**Marks & Clerk France**
**31-33 Avenue Aristide Briand**
**94117 Arcueil Cedex (FR)**

(56) Documents cités:
• **CARDOSO J F ET AL: "BLIND BEAMFORMING FOR NON-GAUSSIAN SIGNALS" IEE PROCEEDINGS F. COMMUNICATIONS, RADAR & SIGNAL PROCESSING, INSTITUTION OF ELECTRICAL ENGINEERS. STEVENAGE, GB, vol. 140, no. 6, 1 décembre 1993 (1993-12-01), pages 362-370, XP000605067 ISSN: 0956-375X**
• **FERREOL A ET AL: "On the behavior of current second and higher order blind source separation methods for cyclostationary sources" IEEE TRANSACTIONS ON SIGNAL PROCESSING, IEEE, INC. NEW YORK, US, vol. 48, no. 6, juin 2000 (2000-06), pages 1712-1725, XP002226430 ISSN: 1053-587X**
• **FERREOL A ET AL: "HIGHER ORDER BLIND SEPARATION OF NON ZERO-MEAN CYCLOSTATIONARY SOURCES" SIGNAL PROCESSING : THEORIES AND APPLICATIONS, PROCEEDINGS OF EUSIPCO, XX, XX, septembre 2002 (2002-09), XP008027834**
• **CARDOSO J-F ED - INSTITUTE OF ELECTRICAL AND ELECTRONICS ENGINEERS: "Super-symmetric decomposition of the fourth-order cumulant tensor. Blind identification of more sources than sensors" SPEECH PROCESSING 2, VLSI, UNDERWATER SIGNAL PROCESSING. TORONTO, MAY 14 - 17, 1991, INTERNATIONAL CONFERENCE ON ACOUSTICS, SPEECH & SIGNAL PROCESSING. ICASSP, NEW YORK, IEEE, US, vol. VOL. 2 CONF. 16, 14 avril 1991 (1991-04-14), pages 3109-3112, XP010043684 ISBN: 0-7803-0003-3**

**Description**

L'invention concerne notamment un procédé d'identification autodidacte d'un nombre de sources P potentiellement supérieur ou égal au nombre N de capteurs de l'antenne de réception.

Elle peut être utilisée par exemple dans un contexte multiémissions à Bande étroite.

Elle est utilisée par exemple dans un réseau de communications.

Elle trouve son application notamment dans le domaine des radiocommunications, des télécommunications spatiales ou de l'écoute passive de ces liaisons, dans des gammes allant de la VLF à la EHF.

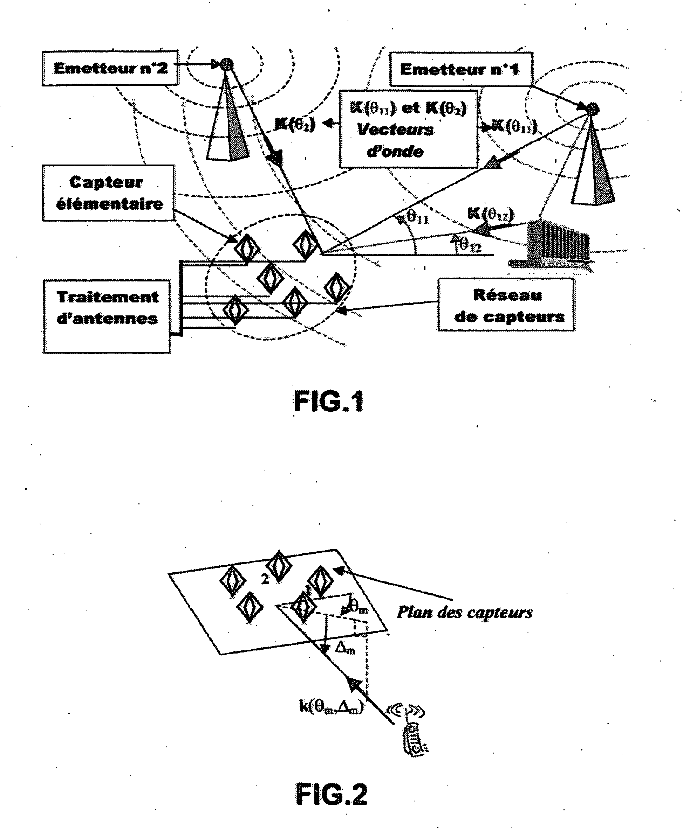

La figure 1 schématise un exemple de réseau comprenant plusieurs capteurs de réception, chaque capteur recevant un ou plusieurs émetteurs de radiocommunication, de directions d'arrivée différentes.

Chaque capteur reçoit une source avec une phase et une amplitude dépendant de l'angle d'incidence de celle-ci et de la position du capteur. La figure 2 schématise un exemple de paramètrage de la direction d'une source. Cette direction est paramétrée par 2 angles correspondant aux angles d'azimut $\theta$ et d'élévation $\Delta$.

Depuis maintenant près d'une quinzaine d'années, de nombreuses techniques d'identification autodidacte de signatures ou vecteurs directeurs de sources, supposées statistiquement indépendantes, ont été développées sous l'hypothèse d'un nombre de sources P inférieur ou égal au nombre de capteurs N, décrites dans les références [1][3] [7] citées en fin de la description. Toutefois pour de nombreuses applications pratiques telles que les radiocommunications HF, le nombre de sources reçues par les capteurs augmente en particulier avec la largeur de bande des récepteurs et le nombre de sources P peut dès lors devenir supérieur au nombre de capteurs N. Les mélanges associés des sources sont alors qualifiés de sous-déterminés.

Un certain nombre de méthodes d'identification autodidacte de mélanges sous-déterminés de sources à bande étroite pour le réseau ont été développées tout récemment et décrites dans les références [2] [7-8] et [10]. Les méthodes proposées dans les références [2] et [7-8] exploitent l'information contenue dans les statistiques d'ordre 4 (FO : Fourth Order) des signaux reçus sur les capteurs tandis que la méthode proposée dans la référence [10] exploite l'information contenue dans une des fonctions caractéristiques des signaux reçus. Toutefois, ces méthodes présentent de grosses limitations dans la perspective d'une mise en oeuvre opérationnelle. En effet, la méthode de la référence [2] est très difficile à mettre en oeuvre et n'assure pas l'identification des sources ayant le même kurtosis (cumulant normalisé d'ordre 4). Les méthodes des références [7-8] supposent que les sources sont non circulaires et conduisent à des résultats peu fiables en pratique. Finalement la méthode de la référence [10] a été développée uniquement pour des mélanges de sources à valeurs réelles (non complexe).

L'objet de la présente invention concerne notamment un nouveau procédé d'identification autodidacte d'un mélange sous-déterminé de sources à bande étroite pour le réseau. Le procédé permet notamment d'identifier jusqu'à $N^2 - N + 1$ sources à partir de N capteurs identiques et jusqu'à $N^2$ sources avec N capteurs différents, en supposant uniquement que les sources ont des trispectres différents et des kurtosis non nuls et de même signe (cette dernière hypothèse est pratiquement toujours vérifiée dans le contexte des radiocommunications).

L'invention concerne un procédé d'identification autodidacte à l'ordre 4 de signatures d'au moins deux sources dans un système comportant un nombre de sources P et un nombre N de capteurs de réception recevant les observations, lesdites sources ayant des tri-spectres différents. Il est caractérisé en ce qu'il comporte au moins les étapes suivantes :

- une étape de blanchiment à l'ordre 4 des observations reçues sur les capteurs de réception afin d'orthonormaliser les vecteurs directeurs des sources dans les matrices de quadricovariance des observations exploitées,
- une étape de diagonalisation conjointe de plusieurs matrices de quadricovariance blanchies afin d'identifier les signatures spatiales des sources.

Le nombre de sources P est par exemple supérieur au nombre de capteurs N.

Le procédé peut être utilisé dans un réseau de communication.

Le procédé selon l'invention présente notamment les avantages suivants :

- Il permet d'identifier un nombre de sources supérieur au nombre de capteurs :

  - pour des capteurs identiques : $N^2 - N + 1$ sources ayant des trispectres différents, des kurtosis non nuls et de même signe,
  - pour des capteurs différents (réseau à diversité de polarisation et/ou à diversité de diagramme et/ou avec du couplage, etc...) $N^2$ sources ayant des trispectres différents, des kurtosis non nuls et de même signe,

- Il est robuste à du bruit Gaussien même corrélé spatialement,
- Il permet une goniométrie de chaque source identifiée, à partir d'un modèle de front d'onde plaqué sur la signature, avec une résolution potentiellement supérieure aux méthodes existantes,

- Il permet l'identification de I (N²-N+1) sources cyclostationnaires si les capteurs sont identiques et I× N² sources cyclostationnaires si les capteurs sont différents : à diversité de polarisation et/ou à diversité de diagramme et/ou avec du couplage, où I est le nombre de fréquences cycliques traitées,
- Au moyen d'un critère de performances, il permet dévaluer quantitativement la qualité d'estimation du vecteur directeur de chaque source, une comparaison quantitative de deux méthodes pour l'identification d'une source donnée,
- A l'aide d'une étape de sélection des fréquences cycliques, il permet de traiter un nombre de sources supérieur au nombre de sources traitées par la méthode de base.

D'autres caractéristiques et avantages de l'invention apparaîtront mieux à la lecture de la description annexée des figures qui représentent :

- La figure 1 un exemple de réseau de communications,
- La figure 2 une représentation des paramètres d'une source,
- La figure 3 un schéma fonctionnel du procédé selon l'invention,
- La figure 4 un exemple de filtrage spatial,
- Les figures 5 et 6 des exemples de variation du critère de performance en fonction du nombre d'échantillons observés comparant les performances du procédé à 2 méthodes de l'art antérieur.
- Les figures 7 à 9 trois variantes de réalisation du procédé décrit à la figure 3 mettant en oeuvre une sélection des fréquences cycliques.

Afin de mieux faire comprendre l'objet de l'invention, l'exemple qui suit est donné à titre illustratif et nullement limitatif pour un réseau de radiocommunication en contexte de multiémissions à Bande étroite, avec des sources ayant des tri-spectres (de cumulants) différents.

Chaque capteur du réseau, composé de N capteurs, reçoit un mélange de P sources à Bande Etroite (BE) supposées statistiquement indépendantes. Sous cette hypothèse, le vecteur des enveloppes complexes des signaux en sortie des capteurs s'écrit :

$$x(t) = \sum_{p=1}^{P} \; s_p(t) \, a_p + b(t) \; = A \; s(t) + b(t) \tag{1}$$

où $s_p(t)$ est le signal de la $p$ième source ainsi que la $p$ième composante du vecteur $s(t)$, $b(t)$ est le vecteur bruit supposé gaussien de covariance quelconque, $a_p$ est la signature ou le vecteur directeur de la $p$ième source et $A$ (N x P) est la matrice des vecteurs $a_p$ (vecteurs directeurs des sources).

L'invention a notamment pour objet d'identifier les vecteurs directeurs $a_p$ de chacune des sources lorsqu'en particulier le nombre de sources $P$ est potentiellement supérieur au nombre de capteurs $N$.

A partir de cette identification, il est ensuite possible d'appliquer des techniques d'extraction des sources par filtrage spatial des observations. L'extraction autodidacte a notamment pour objectif de restituer les signaux informationnels véhiculés par les sources en n'exploitant (en fonctionnement normal) aucune information a priori sur celles-ci.

**Statistique d'ordre 4**

Le procédé selon l'invention exploite les statistiques d'ordre 4 des observations correspondant aux moyennes temporelles, $Q_x(\tau_1, \tau_2, \tau_3) = <Q_x(\tau_1, \tau_2, \tau_3)(t)>$, sur un horizon d'observation infini, de certaines matrices de quadricovariance, $Q_x(\tau_1, \tau_2, \tau_3)(t)$, de dimension ($N^2$x$N^2$). Les éléments, $Q_x(\tau_1,\tau_2,\tau_3)[i,j,k,l](t)$, de ces matrices sont par exemple définis par la relation :

$$Q_x(\tau_1,\tau_2,\tau_3)[i, j, k, l][t] = Cum(x_i(t), x_j(t-\tau_1)^*, x_k(t-\tau_2)^*, x_l(t-\tau_3)) \tag{2}$$

où * est le symbole complexe conjugué, $x_i(t)$ est la $i$ième composante du vecteur $x(t)$, <.> est l'opération de moyennage temporel sur un horizon d'observation infini et $(\tau_1,\tau_2,\tau_3)$ est un triplet de retards. En supposant que $Q_x(\tau_1,\tau_2,\tau_3)[i,j,k,l]$ est l'élément [$N(i$ -1) + $j$, $N(k$-1) + $l$] de la matrice $Q_x(\tau_1,\tau_2,\tau_3)$, en supposant que le bruit est gaussien et en utilisant l'expression (1) dans l'expression (2), la matrice de quadricovariance $Q_x(\tau_1,\tau_2,\tau_3)$ s'écrit de la façon suivante :

$$Q_x(\tau_1, \tau_2, \tau_3) = (A \otimes A^\bullet) Q_s(\tau_1, \tau_2, \tau_3) (A \otimes A^\bullet)^H \qquad (3)$$

où $Q_s(\tau_1,\tau_2,\tau_3)$ est la matrice de quadricovariance moyennée de $s(t)$ de dimension $(P^2 \text{x} P^2)$, $A$=[ $\mathbf{a}_1$ ... $\mathbf{a}_P$], $\oplus$ est le produit de Kronecker et $^H$ désigne le transposé et conjugué. Sous l'hypothèse de sources statistiquement indépendantes la matrice $Q_s(\tau_1,\tau_2,\tau_3)$ est composée d'au moins $P^4$ - $P$ zéros et l'expression (3) se simplifie de la manière suivante :

$$Q_x(\tau_1,\tau_2,\tau_3) = \sum_{p=1}^{P} c_p(\tau_1,\tau_2,\tau_3)(a_p \otimes a_p^\bullet)(a_p \otimes a_p^\bullet)^H \qquad (4a)$$

$$= A_Q \ C_s(\tau_1,\tau_2,\tau_3) \ A_Q^H \qquad (4b)$$

où $A_Q$ est une matrice de dimension $(N^2 \text{x } P)$ définie , par $A_Q = [(\mathbf{a}_1 \otimes \mathbf{a}_1^*), ...., (\mathbf{a}_p \otimes \mathbf{a}_p^*)]$, $C_s(\tau_1,\tau_2,\tau_3)$ est une matrice diagonale de dimension $(P \textbf{ x } P)$ définie par $C_s(\tau_1,\tau_2,\tau_3) = \text{diag}[c_1(\tau_1,\tau_2,\tau_3),..., c_p(\tau_1,\tau_2,\tau_3)]$ et où $c_p(\tau_1,\tau_2,\tau_3)$ est défini par :

$$c_p(\tau_1,\tau_2,\tau_3) = <\text{Cum}(s_p(t), s_p(t-\tau_1)^\bullet, s_p(t-\tau_2)^\bullet, s_p(t-\tau_3))> \qquad (5)$$

L'expression (4b) a une structure algébrique similaire à celle de la matrice de corrélation des observations utilisée dans l'algorithme SOBI décrit dans la référence [1]. On notera dans la suite $Q_x = Q_x(0, 0, 0)$, $c_p = c_p(0, 0, 0)$, $C_s = C_s(0, 0, 0)$ pour en déduire de la relation (4b) :

$$Q_x = A_Q \ C_s \ A_Q^H \qquad (6)$$

On suppose, dans la suite, que le nombre de sources P est tel que $P \leq N^2$, que la matrice $A_Q$ est de rang plein, que les cumulants moyennés $c_p$ , $1 \leq p \leq P,$ sont non nuls (sources non gaussienne) et de même signe et que pour tout couple ($i$, $j$) de sources il existe au moins un triplet de retards $(\tau_1,\tau_2,\tau_3)$ tel que $|\tau_1| + |\tau_2| + |\tau_3| \neq 0$ et

$$c_i(\tau_1,\tau_2,\tau_3) \ / \ |c_i| \neq c_j(\tau_1,\tau_2,\tau_3) \ / \ |c_j| \qquad (7)$$

**Etape de blanchiment à l'ordre 4**

La première étape du procédé selon l'invention, dénommé FOBIUM, consiste à orthonormaliser, dans la matrice de quadricovariance $Q_x$ de l'expression (6), les colonnes de la matrice $A_Q$, considérées comme les vecteurs directeurs virtuels des sources pour le réseau de capteurs considéré. Dans ce but, le procédé considère la décomposition en éléments propres de la matrice hermitienne $Q_x$, de rang $P$, donnée par

$$Q_x = E_x \ \Lambda_x \ E_x^H \qquad (8)$$

où $\Lambda_x$ est la matrice diagonale réelle, de dimension $(P \textbf{ x } P)$, des $P$ valeurs propres non nulles de $Q_x$, et $E_x$ est la matrice de dimension $(N^2 \text{x} P)$ des vecteurs propres orthonormés associés. Pour une matrice $A_Q$ de rang plein, on peut montrer qu'il y a équivalence entre supposer que les kurtosis des sources sont de même signe $\varepsilon$ ($\varepsilon = \pm 1$) et supposer que les valeurs propres de $\Lambda_x$ sont aussi de même signe $\varepsilon$. Dans ce contexte, il est possible de construire la matrice de blanchiment suivante $T$ de dimension $(P \textbf{ x } N^2)$:

$$T = \left(\Lambda_x\right)^{-1/2} E_x^{\,H} \qquad\qquad (9)$$

La matrice de blanchiment de dimension ($P \times N^2$) est définie à partir de la racine carrée de la matrice diagonale réelle de dimension ($P \times P$) des P valeurs propres non nulles de la matrice de quadricovariance et du transposé de la matrice des vecteurs propres associés de dimension ($P \times N^2$) où $(\Lambda_x)^{-1/2}$ est l'inverse de la racine carré de $\Lambda_x$. Des expressions (6) et (8) on en déduit que :

$$\varepsilon\, T\, Q_x\, T^H \;=\; T\, A_Q\, (\varepsilon\, C_s)\, A_Q^H\, T^H \;=\; I_P \qquad\qquad (10)$$

où $I_P$ est la matrice identité de dimension ($P \times P$) et où $\varepsilon C_s = \mathrm{diag}[|c_1|,..., |c_p|]$. Cette dernière expression montre que la matrice $TA_Q\,(\varepsilon C_s)^{1/2}$ de dimension ($P \times P$) est une matrice unitaire $U$. On en déduit alors que :

$$T\, A_Q \;=\; U\, \left(\varepsilon\, C_s\right)^{-1/2} \qquad\qquad (11)$$

**Etape d'identification à l'ordre 4**

On déduit des expressions (4b) et (11) que :

$$W(\tau_1,\tau_2,\tau_3)=TQ_x(\tau_1,\tau_2,\tau_3)T^H=U(\varepsilon C_s)^{-1/2} C_s(\tau_1,\tau_2,\tau_3)\,(\varepsilon C_s)^{-1/2}\, U^H \qquad\qquad (12)$$

où $W(\tau_1,\tau_2,\tau_3)$ est la matrice de quadricovariance blanchie à l'ordre 4 par la matrice $Q_x$. Cette dernière expression montre que la matrice unitaire $U$ diagonalise les matrices $T\, Q_x(\tau_1,\tau_2,\tau_3)\, T^H$ et que les valeurs propres associées sont les termes diagonaux de la matrice diagonale $(\varepsilon C_s)^{-1/2}\, C_s(\tau_1,\tau_2,\tau_3)\,(\varepsilon C_s)^{-1/2}$. Pour un triplet de retards donné $(\tau_1,\tau_2,\tau_3)$, la matrice $U$ est unique à une permutation près et à une matrice diagonale unitaire près, lorsque les éléments de la matrice $(\varepsilon C_s)^{-1/2}\, C_s(\tau_1,\tau_2,\tau_3)\,(\varepsilon C_s)^{-1/2}$ sont tous différents. Dans le cas contraire, le procédé utilise un ensemble de $K$ triplets $(\tau_1^k,\tau_2^k,\tau_3^k)$, $1 \le k \le K$, défini de la manière suivante : pour tous couples de sources $(i, j)$, il existe au moins un triplet $(\tau_1^k,\tau_2^k,\tau_3^k)$, tel que la condition de l'équation (7) soit vérifiée. Dans ces conditions, la matrice unitaire $U$ est la seule matrice $U_{sol}$ qui, à une permutation et une matrice diagonale unitaire près, diagonalise conjointement les $K$ matrices $T\mathbf{x}Q_x(\tau_1^k,\tau_2^k,\tau_3^k)\mathbf{x}T^H$. En conséquence, la matrice $U_{sol}$, solution du problème précédent, s'écrit en fonction de la matrice unitaire $U$ de la manière suivante :

$$U_{sol} \;=\; U\, \Lambda\, \Pi \qquad\qquad (13)$$

où $\Lambda$ et $\Pi$ sont respectivement la matrice diagonale unitaire et la matrice de permutation citées précédemment. A partir des équations (11) et (13), il est possible de déduire la matrice $A_Q$ à une matrice diagonale unitaire et de permutation près, qui s'exprime par :

$$T^{\#}\, U_{sol} \;=\;[b_1\ldots b_P]\;=\; E_x\, \Lambda_x^{1/2}\, U_{sol} \;=\; A_Q\,(\varepsilon\, C_s)^{1/2}\, \Lambda\, \Pi \qquad\qquad (14)$$

où $T^{\#}$ est la pseudo-inverse de la matrice $T$. Chaque colonne , $b_l$ ($1 \le l \le P$), de la matrice $T^{\#}\, U_{sol}$ correspond à l'un des vecteurs $\mu_q\,|c_q|^{1/2}\,(a_q \otimes a_q^*)$, $1 \le q \le P$, où $\mu_q$ est un scalaire complexe tel que $|\mu_q| = 1$. En conséquence, en transformant chaque colonne $b_l$ de la matrice $T^{\#}\, U_{sol}$ en une matrice $B_l$ de dimension ($N \times N$) tel que $B_l[i,j] = b_l((i-1)N+j)$ ($1 \le i, j \le N$) on en déduit que:

$$B_l = \mu_q \, |c_q|^{1/2} \, a_q \, a_q^{H} \quad \text{pour} \quad (1 \leq l, q \leq P) \qquad\qquad (15)$$

La matrice $B_l$ est construite à partir du vecteur $b_l$ et dépend d'un scalaire complexe, de la racine carrée du cumulant et du vecteur directeur de la $q^{ième}$ source et de son conjugué.

Dans ce contexte le vecteur directeur $a_q$ de la $q^{ième}$ source est associé au vecteur propre de $B_l$ associé à la plus forte valeur propre.

## Résumé du principe de l'invention

En résumé, les différentes étapes du procédé selon l'invention comportent au moins les étapes suivantes : pour $L$ observations vectorielles reçue au cours du temps : $x(lT_e)$ $(1 \leq l \leq L)$, où $T_e$ est la période d'échantillonnage.

## Estimation

**Etape 1:** Estimer, par $\hat{Q}_x$, la matrice de quadricovariance $Q_x$, à partir des $L$ observations $x(lT_e)$, en utilisant un estimateur non biaisé et asymptotiquement consistant. Suivant la nature des sources, l'estimateur est adapté comme suit :

- *Cas stationnaire et centré* : Estimateur empirique utilisé dans la référence [3].
- *Cas cyclo-stationnaire et centré* : Estimateur mis en oeuvre dans la référence [10].
- *Cas cyclo-stationnaire et non-centré* : Estimateur mis en oeuvre dans la référence [11].

## Blanchiment

**Etape 2:** Décomposer en éléments propres la matrice de quadricovariance estimée $\hat{Q}_x$, estimer le nombre de sources $P$ et restreindre cette décomposition en éléments propres, aux $P$ composantes principales : $\hat{Q}_x \approx \hat{E}_x \hat{\Lambda}_x \hat{E}_x^{H}$, où $\hat{\Lambda}_x$ est la matrice diagonale contenant les $P$ valeurs propres de plus fort module et $\hat{E}_x$ est la matrice contenant les vecteurs propres associés.

**Etape 3 :** Construire la matrice de blanchiment : $\hat{T} = (\hat{\Lambda}_x)^{-1/2} \hat{E}_x^{H}$.

## Sélection des triplets

**Etape 4** : Sélectionner $K$ triplets de retards $(\tau_1^k, \tau_2^k, \tau_3^k)$ où $|\tau_1^k| + |\tau_2^k| + |\tau_3^k| \neq 0$.

## Estimation

**Etape 5 :** Estimer, par $\hat{Q}_x(\tau_1^k, \tau_2^k, \tau_3^k)$, $K$ matrices de quadricovariance $Q_x(\tau_1^k, \tau_2^k, \tau_3^k)$. Comme dans l'étape 1 cette estimation dépend notamment des hypothèses faites sur les observations:

- *Cas stationnaire et centré* : Estimateur empirique utilisé dans la référence [3].
- Cas *cyclo-stationnaire et centré* : Estimateur mis en oeuvre dans la référence [10].
- *Cas cyclo-stationnaire et non-centré* : Estimateur mis en oeuvre dans la référence [11].

## Identification

**Etape 6 :** Calculer les matrices $\hat{T} \hat{Q}_x(\tau_1^k, \tau_2^k, \tau_3^k) \hat{T}^{H}$ et estimer, par $\hat{U}_{sol}$, la matrice unitaire $U_{sol}$ par diagonalisation conjointe des $K$ matrices $\hat{T} \hat{Q}_x(\tau_1^k, \tau_2^k, \tau_3^k) \hat{T}^{H}$.

**Etape 7 :** Calculer $\hat{T}^{\#}\hat{U}_{sol} = [\hat{b}_1 ... \hat{b}_P]$ et construire les matrices $\hat{B}_l$ de dimension ($N$ x $N$).

**Etape 8** : Estimer, par $\hat{a}_P$, les signatures $a_q$ $(1 \leq q \leq P)$ des $P$ sources en appliquant une décomposition en élément sur chaque matrice $\hat{B}_l$.

## Applications

A l'issue de l'étape 8, le procédé a identifié les vecteurs directeurs de P sources non gaussiennes ayant des tri-spectres différents avec des kurtosis de mêmes signes. $P < N^2$ et P peuvent atteindre $N^2 - N + 1$ ou $N^2$ selon le type de capteurs utilisés.

A l'aide de ces informations, le procédé peut mettre en oeuvre une méthode de goniométrie ou un filtrage spatial d'antennes.

Une méthode de goniométrie permet de déterminer la direction d'arrivée des sources et plus précisément les angles d'azimut, $\theta_m$ pour la goniométrie en 1D et azimut et site ($\theta_m$, $\Delta_m$) pour la goniométrie 2D.

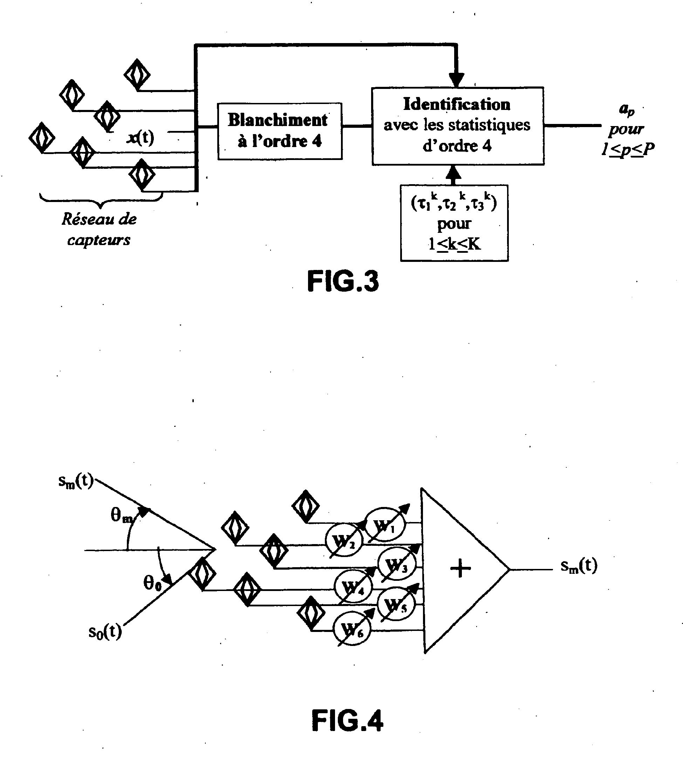

La figure 4 représente un filtrage spatial d'antennes, pour des structures spatiales de filtrage. Il permet notamment d'optimiser la réception d'une ou de toutes les sources présentes par filtrage spatial des observations. Lorsque plusieurs sources sont d'intérêt pour le récepteur, on parle de techniques de séparation de sources. Lorsque qu'aucune information a priori n'est exploitée sur les sources, on parle de techniques autodidactes.

## Vérification de la qualité des estimées

Selon une variante de réalisation, le procédé comporte une étape permettant l'évaluation quantitative, pour chaque source, de la qualité de l'identification du vecteur directeur associé.

Ce nouveau critère permet la comparaison intrinsèque de deux méthodes d'identification pour la restitution de la signature d'une source particulière. Ce critère, pour le problème de l'identification, est l'extension de celui proposé dans [5] pour l'extraction. Il est défini par le *P*-uplet :

$$D(A, \hat{A}) = (\alpha_1, \alpha_2, \ldots, \alpha_P) \qquad (16)$$

où

$$\alpha_p = \min_{1 \le i \le P} [d(a_p, \hat{a}_i)] \qquad (17)$$

et où d($u,v$) est la pseudo-distance entre les vecteurs $u$ et $v$, tel que :

$$d(u, v) = 1 - \frac{\left|u^H v\right|^2}{\left(u^H u\right)\left(v^H v\right)} \qquad (18)$$

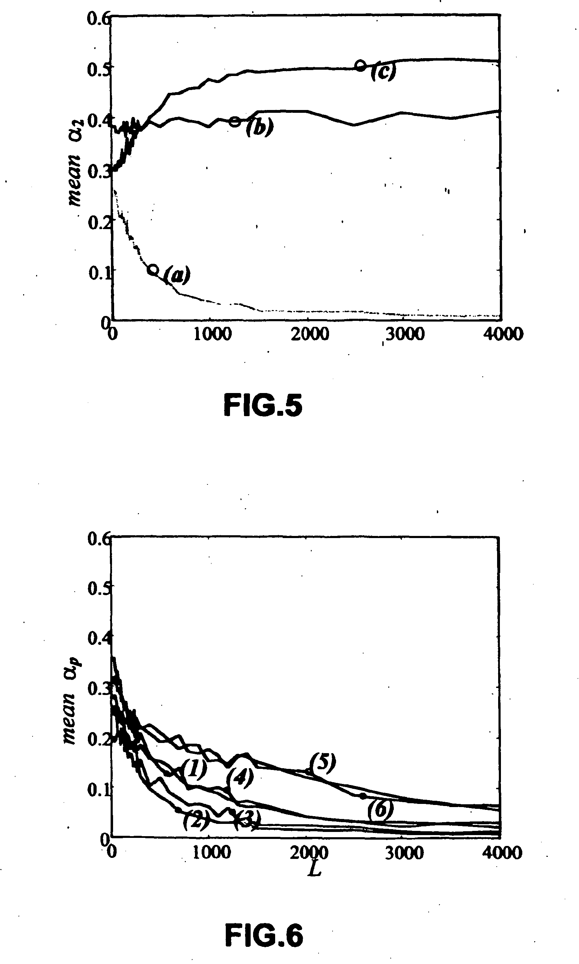

Dans les simulations des figures 5 et 6, on est en présence de *P*=6 sources statistiquement indépendantes reçues sur un réseau circulaire de *N*=3 capteurs de rayon *r* tel que $r/\lambda$=0.55 ($\lambda$: longueur d'onde). Les 6 sources sont des sources QPSK non filtrées ayant 20dB de rapport signal sur bruit avec une période symbole $T = 4T_e$, où $T_e$ est la période d'échantillonnage.

Les incidences des sources sont telles que $\theta_1$=2.16˚, $\theta_2$=25.2˚, $\theta_3$=50˚, $\theta_4$=272.16˚, $\theta_5$=315.36˚, $\theta_6$=336.96˚ et les fréquences porteuses associées vérifient $\Delta f_1 T_e$=0, $\Delta f_2 T_e$=1/2, $\Delta f_3 T_e$=1/3, $\Delta f_4 T_e$=1/5, $\Delta f_5 T_e$=1/7 et $\Delta f_6 T_e$=1/11. Les méthodes JADE [3], SOBI [1] et FOBIUM selon l'invention sont appliqués et les performances $\alpha_q$ pour *q*=1...6 sont évaluées après un moyennage sur 1000 réalisations. Pour la méthode FOBIUM on choisit K=4 triplets de retards ($\tau_1^k$, $\tau_2^k, \tau_3^k$) où $\tau_1^{k} = kT_e$ et $\tau_2^{k} = \tau_3^{k}$=0.

Sous les hypothèses précédentes, la figure 5 montre la variation de $\alpha_2$ (performances de la 2ième source) en sortie des séparateurs JADE (b), SOBI (c) et FOBIUM (a) en fonction du nombre L d'échantillons. Les courbes montrent d'une part que les méthodes JADE et SOBI ont des difficultés à identifier le vecteur directeur de la 2ième source dans un contexte de mélange sous-déterminé et que d'autre part la méthode FOBIUM a de très bonnes performances.

La Figure 6 montre, dans le même contexte, les variations de tous les $\alpha_p$ ($1 \le p \le 6$) en sortie de la méthode FOBIUM en fonction de *L*. La courbe (indice p) est associé à la p^{ième} source. On remarque que tous les coefficients $\alpha_p$ convergent vers zéros et que asymptotiquement les vecteurs directeurs sont parfaitement identifiés.

## Variantes de réalisation cyclique

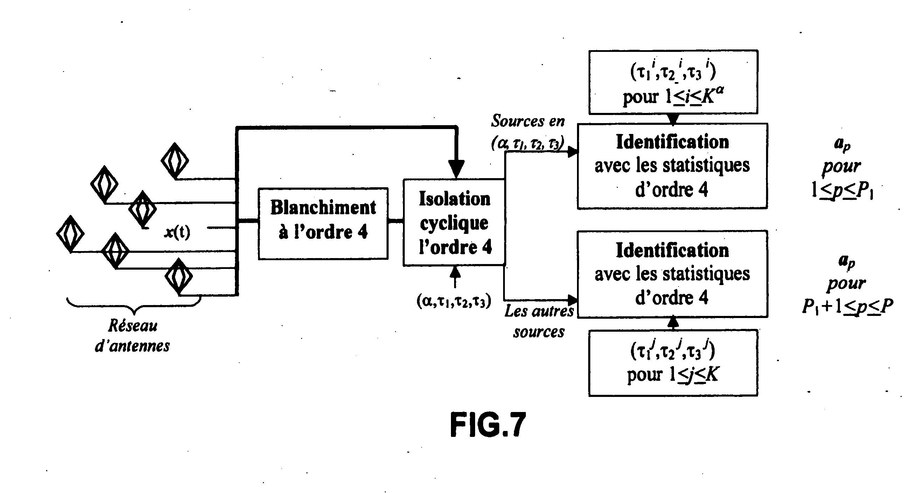

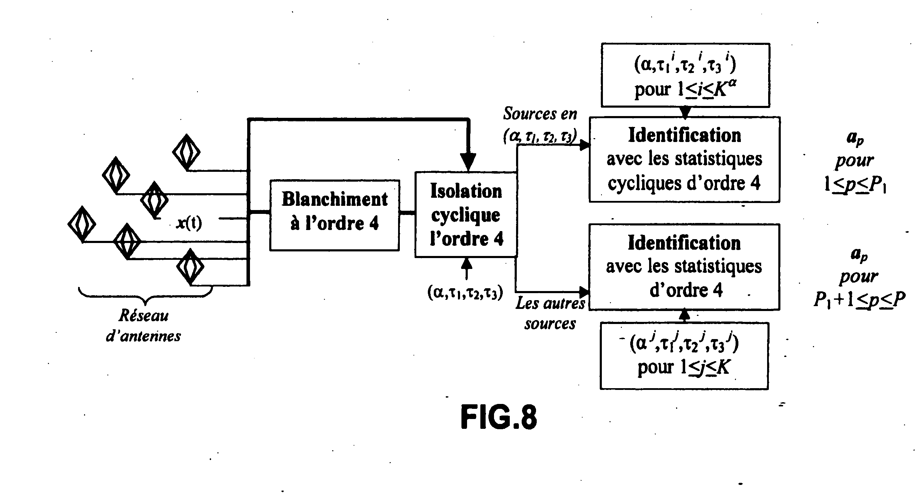

Les figures 7 et 8 représentent deux exemples de variantes de réalisation selon l'invention dénommées FOBIUM cyclique.

L'idée consiste notamment à introduire une sélectivité par les fréquences cycliques dans le procédé présenté ci-dessus et vise en particulier à identifier de manière autodidacte et avec une capacité de traitement plus importante, des mélanges sous-déterminés de sources cyclostationnaires.

La différence majeure entre les étapes 1 à 8 explicitées ci-dessus et cette variante de réalisation est la mise en oeuvre d'une étape d'isolation cyclique des sources par discrimination selon leurs fréquences cycliques à l'ordre 4. De cette façon, il est possible d'identifier séparément les sources associées à un même paramètre cyclique à l'ordre 4 sans être perturbé par les autres sources traitées séparément.

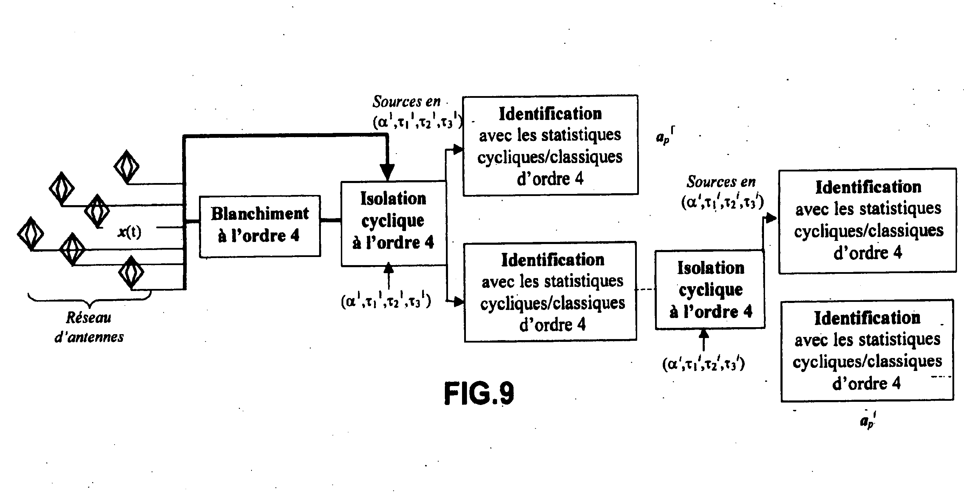

Les deux variantes présentées aux figures 7 et 8 peuvent être mises en oeuvre en réitérant le processus d'isolation cyclique sur les « autres sources » avec d'autres paramètres cycliques. Le processus d'isolation cyclique peut s'appliquer plusieurs fois dans une troisième version illustré sur la figure 9.

## Statistiques cycliques d'ordre 4

Les statistiques d'ordre 4 cycliques des observations ou des signaux capteurs utilisées sont caractérisées par les matrices de quadricovariance cyclique $Q_x^\varepsilon(\alpha,\tau_1,\tau_2,\tau_3)$ de dimension $(N^2 \times N^2)$ où les éléments $Q_x^\varepsilon(\alpha,\tau_1,\tau_2,\tau_3)[i,j,k,l]$, sont définis par :

$$Q_x^1(\alpha,\tau_1,\tau_2,\tau_3)\,[i,j,k,l] \;=\; <\mathrm{Cum}(x_i(t),\,x_j(t-\tau_1)^*,\,x_k(t-\tau_2)^*,\,x_l(t-\tau_3))\exp(-j2\pi\alpha t)>$$

$$Q_x^2(\alpha,\tau_1,\tau_2,\tau_3)\,[i,j,k,l] \;=\; <\mathrm{Cum}(x_i(t),\,x_j(t-\tau_1)^*,\,x_k(t-\tau_2),\,x_l(t-\tau_3))\exp(-j2\pi\alpha t)>$$

$$Q_x^3(\alpha,\tau_1,\tau_2,\tau_3)\,[i,j,k,l] \;=\; <\mathrm{Cum}(x_i(t),\,x_j(t-\tau_1),\,x_k(t-\tau_2),\,x_l(t-\tau_3))\exp(-j2\pi\alpha t)> \qquad (19)$$

On note que $Q_x^\varepsilon(\alpha,\tau_1,\tau_2,\tau_3)$ est associé au $\varepsilon^{ième}$ moment d'ordre 4. En posant que $Q_x^\varepsilon(\alpha,\tau_1,\tau_2,\tau_3)[i,j,k,l]$ est l'élément $[N(i-1)+j,\,N(k-1)+l]$ de la matrice $Q_x^\varepsilon(\alpha,\tau_1,\tau_2,\tau_3)$ et supposant que le bruit est gaussien la matrice $Q_x^\varepsilon(\alpha,\tau_1,\tau_2,\tau_3)$, s'écrit de la façon suivante en utilisant (1) et (19) :

$$Q_x^1(\alpha,\tau_1,\tau_2,\tau_3) \;=\; (A \otimes A^*)\,Q_s^1(\alpha,\tau_1,\tau_2,\tau_3)\,(A \otimes A^*)^H$$

$$Q_x^2(\alpha,\tau_1,\tau_2,\tau_3) \;=\; (A \otimes A^*)\,Q_s^2(\alpha,\tau_1,\tau_2,\tau_3)\,(A \otimes A)^T$$

$$Q_x^3(\alpha,\tau_1,\tau_2,\tau_3) \;=\; (A \otimes A)\,Q_s^3(\alpha,\tau_1,\tau_2,\tau_3)\,(A \otimes A)^T \qquad (20)$$

Où $Q_s^\varepsilon(\alpha,\tau_1,\tau_2,\tau_3)$ est une matrice de quadricovariance cyclique de $s(t)$ de dimension $(P^2 \times P^2)$, $\otimes$ est le produit de Kronecker et $^T$ désigne le transposé. Sous l'hypothèse de sources statistiquement indépendantes la matrice $Q_s^\varepsilon(\alpha,\tau_1,\tau_2,\tau_3)$ est composée d'au moins $P^4 - P$ zéros et l'expression (20) se simplifie de la manière suivante :

$$Q_x^1(\alpha,\tau_1,\tau_2,\tau_3) = \sum_{p=1}^{P} c_p^1(\alpha,\tau_1,\tau_2,\tau_3)\,(a_p \otimes a_p^*)\,(a_p \otimes a_p^*)^H \;=\; A_Q\,C_s^1(\alpha,\tau_1,\tau_2,\tau_3)\,A_Q^{\,H}$$

$$Q_x^2(\alpha,\tau_1,\tau_2,\tau_3) = \sum_{p=1}^{P} c_p^2(\alpha,\tau_1,\tau_2,\tau_3)\,(a_p \otimes a_p^*)\,(a_p \otimes a_p)^T \;=\; A_Q\,C_s^2(\alpha,\tau_1,\tau_2,\tau_3)\,B_Q^{\,T}$$

$$Q_x^3(\alpha,\tau_1,\tau_2,\tau_3) = \sum_{p=1}^{P} c_p^3(\alpha,\tau_1,\tau_2,\tau_3)\,(a_p \otimes a_p)\,(a_p \otimes a_p)^T \;=\; B_Q\,C_s^3(\alpha,\tau_1,\tau_2,\tau_3)\,B_Q^{\,T} \qquad (21)$$

où $A_Q$ et $B_Q$ sont des matrices de dimension $(N^2 \times P)$ définie par $A_Q = [(a_1 \otimes a_1^*),\,....,\,(a_p \otimes a_p^*)]$ et $B_Q = [(a_1 \otimes a_1),\,....,\,(a_p \otimes a_p)]$, $C_s^\varepsilon(\alpha,\tau_1,\tau_2,\tau_3)$ est une matrice diagonale de dimension $(P \times P)$ définie par $C_s^\varepsilon(\alpha,\tau_1,\tau_2,\tau_3) = \mathrm{diag}[c_1^\varepsilon(\alpha,\tau_1,\tau_2,\tau_3),....,\,c_p^\varepsilon(\alpha,\tau_1,\tau_2,\tau_3)]$ et où $c_p^\varepsilon(\alpha,\tau_1,\tau_2,\tau_3)$ est défini par :

$$c_p^{1}(\alpha, \tau_1, \tau_2, \tau_3) = <\mathrm{Cum}(s_p(t), s_p(t-\tau_1)^{\bullet}, s_p(t-\tau_2)^{\bullet}, s_p(t-\tau_3))\exp(-j2\pi\alpha t)>$$

$$c_p^{2}(\alpha, \tau_1, \tau_2, \tau_3) = <\mathrm{Cum}(s_p(t), s_p(t-\tau_1)^{\bullet}, s_p(t-\tau_2), s_p(t-\tau_3))\exp(-j2\pi\alpha t)>$$

$$c_p^{3}(\alpha, \tau_1, \tau_2, \tau_3) = <\mathrm{Cum}(s_p(t), s_p(t-\tau_1), s_p(t-\tau_2), s_p(t-\tau_3))\exp(-j2\pi\alpha t)> \qquad (22)$$

On note que la quadricovariance classique de (6) vérifie aussi que $Q_x = Q_x^{1}(0, 0, 0, 0)$, $c_p = c_p^{1}(0, 0, 0, 0)$, $C_s = C_s^{1}(0,0, 0, 0)$. En rappelant que $Q_x[i, j, k, l]$ est l'élément $[N(i-1) + j, N(k-1) + l]$ de la matrice $Q_x$, on en déduit:

$$Q_x = A_Q C_s A_Q^{H} \qquad (23)$$

En posant que $Q_x[i, j, k, l]$ est l'élément $[N(i-1) + l, N(k-1) + j]$ de $\tilde{Q}_x$ on obtient la matrice $\tilde{Q}_x$ qui s'écrit de la façon suivante :

$$\tilde{Q}_x = B_Q C_s B_Q^{H} \qquad (24)$$

**Etape de blanchiment**

La première étape du procédé cyclique orthonormalise les colonnes des matrices $A_Q$ ou $B_Q$ contenues dans les matrices $Q_x$ ou $\tilde{Q}_x$ des expressions (23)(24). Les matrices $Q_x$ et $\tilde{Q}_x$ sont hermitiennes de rang $P$ et vérifient la décomposition en éléments propres suivantes :

$$Q_x = E_x \Lambda_x E_x^{H} \quad \text{et} \quad \tilde{Q}_x = \tilde{E}_x \tilde{\Lambda}_x \tilde{E}_x^{H} \qquad (25)$$

Où $\hat{\Lambda}_x$ est la matrice diagonale de dimension ($P$ x $P$) des $P$ valeurs non nulles de $\tilde{Q}_x$ et $\tilde{E}_x$ est la matrice de dimension ($N^2$x$P$) des vecteurs propres associés. Pour une matrice $B_Q$ de rang plein, on peut montrer qu'il y a équivalence entre supposer que les kurtosis des sources sont de même signe $\varepsilon$ ($\varepsilon = \pm 1$) et supposer que les valeurs propres de $\tilde{\Lambda}_x$ sont aussi de même signe $\varepsilon$. Dans ce contexte, il est possible de construire la matrice de blanchiment suivante $\tilde{T}$ de dimension ($P$ **x** $N^2$):

$$\tilde{T} = (\tilde{\Lambda}_x)^{-1/2} \tilde{E}_x^{H} \qquad (26)$$

où $(\tilde{\Lambda}_x)^{-1/2}$ est l'inverse de la racine carré de $\tilde{\Lambda}_x$. Des expressions (24) et (25) on en déduit que :

$$\varepsilon \tilde{T} \tilde{Q}_x \tilde{T}^{H} = \tilde{T} B_Q (\varepsilon C_s) B_Q^{H} \tilde{T}^{H} = I_P \qquad (27)$$

Cette dernière expression montre que la matrice $\tilde{T} B_Q (\varepsilon C_s)^{1/2}$ de dimension ($P$ **x** $P$) est une matrice unitaire $\tilde{U}$. On en déduit alors que :

$$\tilde{T} B_Q = \tilde{U} (\varepsilon C_s)^{-1/2} \qquad (28)$$

On rappelle que la matrice $T$ de blanchiment de $Q_x$ vérifie :

$$T A_Q = U (\varepsilon C_s)^{-1/2} \qquad (29)$$

**Etape d'isolation cyclique**

On déduit des expressions (28)(29) et (21) que :

$$W_x^1(\alpha,\tau_1,\tau_2,\tau_3) = T\,Q_x^1(\alpha,\tau_1,\tau_2,\tau_3)\,T^H = U\,(\varepsilon C_s)^{-1/2} C_s^1(\alpha,\tau_1,\tau_2,\tau_3)\,(\varepsilon C_s)^{-1/2}\,U^H$$

$$W_x^2(\alpha,\tau_1,\tau_2,\tau_3) = T\,Q_x^2(\alpha,\tau_1,\tau_2,\tau_3)\,\widetilde{T}^{\mathrm{T}} = U\,(\varepsilon C_s)^{-1/2} C_s^2(\alpha,\tau_1,\tau_2,\tau_3)\,(\varepsilon C_s)^{-1/2}\,\widetilde{U}^{\mathrm{T}}$$

$$W_x^2(\alpha,\tau_1,\tau_2,\tau_3) = \widetilde{T}\,Q_x^2(\alpha,\tau_1,\tau_2,\tau_3)\,\widetilde{T}^{\mathrm{T}} = \widetilde{U}\,(\varepsilon C_s)^{-1/2} C_s^3(\alpha,\tau_1,\tau_2,\tau_3)\,(\varepsilon C_s)^{-1/2}\,\widetilde{U}^{\mathrm{T}} \qquad (30)$$

En présence de $P_1$ sources vérifiant $c_i^\varepsilon(\alpha, \tau_1, \tau_2, \tau_3)\neq 0$ ($1\leq i \leq P_1$) la matrice $W_x^\varepsilon(\alpha,\tau_1,\tau_2,\tau_3)$ est de rang $P_1\leq P$. Dans ces conditions les matrices unitaires $U$ et $\widetilde{U}$ de dimension $P\mathbf{x}P$ peuvent se décomposer en deux sous matrices de dimension $P\mathbf{x}P_1$ et $P\mathbf{x}(P - P_1)$ tel que :

$$U = [U_1\ \ U_2]\ \text{ et }\ \ \widetilde{U} = [\widetilde{U}_1\ \ \widetilde{U}_2] \qquad\qquad (31)$$

où les matrices $U_1$ et $\widetilde{U}_1$ sont de dimension $P\mathbf{x}P_1$ et $U_2$ et $\widetilde{U}_2$ sont de dimension $P\mathbf{x}(P-P_1)$. Les matrices $U_1$ et $\widetilde{U}_1$ contiennent les vecteurs singuliers associés aux valeurs singulières non nulles de $W_x^\varepsilon(\alpha, \tau_1, \tau_2, \tau_3)$. On en déduit alors que :

$$W_x^1(\alpha,\tau_1,\tau_2,\tau_3) = T\,Q_x^1(\alpha,\tau_1,\tau_2,\tau_3)\,T^H = U_1\,(\varepsilon \widetilde{C}_s)^{-1/2}\,\widetilde{C}_s^{\ 1}(\alpha,\tau_1,\tau_2,\tau_3)\,(\varepsilon\widetilde{C}_s)^{-1/2}\,U_1^H$$

$$W_x^2(\alpha,\tau_1,\tau_2,\tau_3) = T\,Q_x^2(\alpha,\tau_1,\tau_2,\tau_3)\,\widetilde{T}^{\mathrm{T}} = U_1\,(\varepsilon \widetilde{C}_s)^{-1/2}\,\widetilde{C}_s^{\ 2}(\alpha,\tau_1,\tau_2,\tau_3)\,(\varepsilon\widetilde{C}_s)^{-1/2}\,\widetilde{U}_1^{\mathrm{T}}$$

$$W_x^3(\alpha,\tau_1,\tau_2,\tau_3) = \widetilde{T}\,Q_x^3(\alpha,\tau_1,\tau_2,\tau_3)\,\widetilde{T}^{\mathrm{T}} = \widetilde{U}_1\,(\varepsilon \widetilde{C}_s)^{-1/2}\,\widetilde{C}_s^{\ 3}(\alpha,\tau_1,\tau_2,\tau_3)\,(\varepsilon\widetilde{C}_s)^{-1/2}\,\widetilde{U}_1^{\mathrm{T}}$$
$$(32)$$

Où la matrice $\widetilde{C}_s^{\ \varepsilon}(\alpha,\tau 1,\tau 2,\tau 3)$ est une matrice diagonale de dimensions $P_1\mathbf{x}P_1$ composé des éléments diagonaux $c_i^\varepsilon(\alpha, \tau 1,\tau 2,\tau 3)$ non nul de $C_s^\varepsilon(\alpha\tau_1,\tau_2,\tau_3)$. La matrice $\widetilde{C}_s = \widetilde{C}_s^{\ 1}(0,0,0,0)$ de dimension $P_1\mathbf{x}P_1$ est composée des éléments $c_i$ ($1\leq i\leq P_1$) correspondants. Dans ces conditions après une décomposition en valeurs singulières de $W_x^\varepsilon(\alpha,\tau 1,\tau 2,\tau 3)$, on peut déterminer les matrices $T_1$ et $\widetilde{T}$ à partir des vecteurs singuliers associé aux valeurs singulières non nulles et $T_2$ et $\widetilde{T}_2$ à partir des vecteurs singuliers associé aux valeurs singulières nulles tel que :

$$T_1 = U_1\,\Pi_1^{\mathrm{H}}\ \ ,\ T_2 = U_2\,\Pi_2^{\mathrm{H}},\ \ \widetilde{T}_1 = \widetilde{U}_1\,\widetilde{\Pi}_1^{\mathrm{H}}\ \text{et}\ \ \widetilde{T}_2 = \widetilde{U}_2\,\widetilde{\Pi}_2^{\mathrm{H}} \qquad\qquad (33)$$

Où les matrices sont $\Pi_1$, $\Pi_2$, $\widetilde{\Pi}_1$ et $\widetilde{\Pi}_2$ sont unitaires. On peut construire à partir de $W_x^\varepsilon{}'(\alpha',\tau_1',\tau_2',\tau_3')$ une matrice $\widetilde{W}_x^\varepsilon{}'(\alpha',\tau_1',\tau_2',\tau_3')$ dépendant uniquement des sources de paramètres cyclique $(\alpha,\tau_1,\tau_2,\tau_3,\varepsilon)$ tel que $c_i^\varepsilon(\alpha,\tau_1,\tau_2, \tau_3)\neq 0$. Pour ce faire on effectue le calcul suivant :

$$\widetilde{W}_x^1(\alpha',\tau_1',\tau_2',\tau_3')= T_1^H\, W_x^1(\alpha',\tau_1',\tau_2',\tau_3')\, T_1 = \Pi_1\,(\varepsilon\,\widetilde{C}_s)^{-1/2}\,\widetilde{C}_s^{\,1}(\alpha',\tau_1',\tau_2',\tau_3')\,(\varepsilon\widetilde{C}_s)^{-1/2}\,\Pi_1^H$$

$$\widetilde{W}_x^2(\alpha',\tau_1',\tau_2',\tau_3')= T_1^H\, W_x^2(\alpha',\tau_1',\tau_2',\tau_3')\,\widetilde{T}_1^{\,*}= \Pi_1\,(\varepsilon\,\widetilde{C}_s)^{-1/2}\,\widetilde{C}_s^{\,2}(\alpha',\tau_1',\tau_2',\tau_3')\,(\varepsilon\widetilde{C}_s)^{-1/2}\,\widetilde{\Pi}_1^{\,T}$$

$$\widetilde{W}_x^3(\alpha',\tau_1',\tau_2',\tau_3')= \widetilde{T}_1^{\,H}\, W_x^3(\alpha',\tau_1',\tau_2',\tau_3')\,\widetilde{T}_1^{\,*}= \widetilde{\Pi}_1\,(\varepsilon\,\widetilde{C}_s)^{-1/2}\,\widetilde{C}_s^{\,3}(\alpha',\tau_1',\tau_2',\tau_3')\,(\varepsilon\widetilde{C}_s)^{-1/2}\,\widetilde{\Pi}_1^{\,T}$$

(34)

De même on peut construire à partir de $W_x^{\varepsilon'}(\alpha',\tau_1',\tau_2',\tau_3')$ une matrice $\widetilde{W}_x^{\varepsilon'}(\alpha',\tau_1',\tau_2',\tau_3')$ ne dépendant pas des sources de paramètres cyclique $(\alpha,\tau_1,\tau_2,\tau_3,\varepsilon)$ tel que $c_i^\varepsilon(\alpha,\tau_1,\tau_2,\tau_3)=0$ : Autres sources. Pour ce faire on effectue le calcul suivant :

$$\widetilde{\widetilde{W}}_x^1(\alpha',\tau_1',\tau_2',\tau_3')= T_2^H\, W_x^1(\alpha',\tau_1',\tau_2',\tau_3')\, T_2 = \Pi_2\,(\varepsilon\,\widetilde{\widetilde{C}}_s)^{-1/2<}\,\widetilde{\widetilde{C}}_s^{\,1}(\alpha',\tau_1',\tau_2',\tau_3')\,(\varepsilon\widetilde{\widetilde{C}}_s)^{-1/2}\,\Pi_2^H$$

$$\widetilde{\widetilde{W}}_x^2(\alpha',\tau_1',\tau_2',\tau_3')= T_2^H\, W_x^2(\alpha',\tau_1',\tau_2',\tau_3')\,\widetilde{T}_2^{\,*}= \Pi_2\,(\varepsilon\,\widetilde{\widetilde{C}}_s)^{-1/2}\,\widetilde{\widetilde{C}}_s^{\,2}(\alpha',\tau_1',\tau_2',\tau_3')\,(\varepsilon\widetilde{\widetilde{C}}_s)^{-1/2}\,\widetilde{\Pi}_2^{\,T}$$

$$\widetilde{\widetilde{W}}_x^3(\alpha',\tau_1',\tau_2',\tau_3')= \widetilde{T}_2^{\,H}\, W_x^3(\alpha',\tau_1',\tau_2',\tau_3')\,\widetilde{T}_2^{\,*}= \widetilde{\Pi}_2\,(\varepsilon\,\widetilde{\widetilde{C}}_s)^{-1/2}\,\widetilde{\widetilde{C}}_s^{\,3}(\alpha',\tau_1',\tau_2',\tau_3')\,(\varepsilon\widetilde{\widetilde{C}}_s)^{-1/2}\,\widetilde{\Pi}_2^{\,T}$$

(35)

Où la matrice $\widetilde{C}_x^{\varepsilon'}(\alpha',\tau_1',\tau_2',\tau_3')$ est une matrice diagonale de dimensions $(P-P_1)\mathbf{x}(P-P_1)$ composé des éléments diagonaux $c_i^{\varepsilon'}(\alpha',\tau 1',\tau 2',\tau 3')$ tel que les $c_i^\varepsilon(\alpha,\tau_1,\tau_2,\tau_3)$ correspondants sont nuls. La matrice $\widetilde{C}_s$ de dimension $(P-P_1)\mathbf{x}(P-P_1)$ est composé des éléments $c_i$ $(1\leq i\leq P_1)$ correspondants.

En particulier dans la 1$^{ière}$ version de cette variante on peut effectué l'isolation cyclique en $\alpha'=0$ et $\varepsilon'=1$. En posant $W(\tau_1',\tau_2',\tau_3') = W_x^{\varepsilon'}(\alpha',\tau_1',\tau_2',\tau_3')$ , $\widetilde{C}_s(\tau_1',\tau_2',\tau_3') = \widetilde{C}_s^\varepsilon(\alpha',\tau_1',\tau_2',\tau_3')$ et $\widetilde{\widetilde{C}}_s(\alpha',\tau_1',\tau_2',\tau_3') = \widetilde{\widetilde{C}}_s^\varepsilon(\alpha',\tau_1',\tau_2',\tau_3')$, les équations (34) et (35) deviennent :

$$\widetilde{W}_x(\tau_1',\tau_2',\tau_3')= T_1^H\, W_x(\tau_1',\tau_2',\tau_3')\, T_1 = \Pi_1\,(\varepsilon\,\widetilde{C}_s)^{-1/2}\,\widetilde{C}_s(\tau_1',\tau_2',\tau_3')\,(\varepsilon\widetilde{C}_s)^{-1/2}\,\Pi_1^H$$

(36)

$$\widetilde{\widetilde{W}}_x(\tau_1',\tau_2',\tau_3')= T_2^H\, W_x(\tau_1',\tau_2',\tau_3')\, T_2 = \Pi_2\,(\varepsilon\,\widetilde{\widetilde{C}}_s)^{-1/2}\,\widetilde{\widetilde{C}}_s(\tau_1',\tau_2',\tau_3')\,(\varepsilon\widetilde{\widetilde{C}}_s)^{-1/2}\,\Pi_2^H$$

(37)

**Etape d'identification**

Les équations (34) et (36) montrent que l'on peut identifier les matrices unitaires $\Pi_1$ et $\widetilde{\Pi}_1$ associées aux sources de paramètres cyclique $(\alpha,\tau_1,\tau_2,\tau_3,\varepsilon)$ en effectuant la SVD(Singular Value Decomposition) conjointe des matrices $\widetilde{W}_x^{\varepsilon'}(\alpha^j,\tau_1^j,\tau_2^j,\tau_3^j)$ pour $1\leq j\leq K$. Ainsi pour estimer la matrice unitaire de gauche on effectue la diagonalisation conjointe des matrices :

$$\widetilde{W}_x^{\varepsilon'}(\alpha^j,\tau_1^j,\tau_2^j,\tau_3^j)\,\widetilde{W}_x^{\varepsilon'}(\alpha^j,\tau_1^j,\tau_2^j,\tau_3^j)^H \qquad \text{pour } 1\leq j\leq K \qquad\qquad (38)$$

et pour estimer la matrices unitaires de droites on effectue la diagonalisation conjointe des matrices :

$$\widetilde{W}_x^{\varepsilon^j}(\alpha^j, \tau_1{}^j, \tau_2{}^j, \tau_3{}^j)^{\mathrm{H}} \; \widetilde{W}_x^{\varepsilon^j}(\alpha^j, \tau_1{}^j, \tau_2{}^j, \tau_3{}^j) \qquad \text{pour } 1 \leq j \leq K \qquad (39)$$

Pour estimer les matrices unitaires $\Pi_2$ et $\tilde{\Pi}_2$ associées aux sources non associées aux paramètres cyclique

$(\alpha, \tau_1, \tau_2, \tau_3, \varepsilon)$, on effectue la SVD conjointe des matrices $\widetilde{\widetilde{W}}_x^{\varepsilon^j}(\alpha^j, \tau_1{}^j, \tau_2{}^j, \tau_3{}^j)$ pour $1 \leq j \leq$ K en diagonalisant conjointement

les matrices $\widetilde{\widetilde{W}}_x^{\varepsilon^j}(\alpha^j, \tau_1{}^j, \tau_2{}^j, \tau_3{}^j)\ \widetilde{\widetilde{W}}_x^{\varepsilon^j}(\alpha^j, \tau_1{}^j, \tau_2{}^j, \tau_3{}^j)^{\mathrm{H}}$ puis les matrices $\widetilde{\widetilde{W}}_x^{\varepsilon^j}(\alpha^j, \tau_1{}^j, \tau_2{}^j, \tau_3{}^j)^{\mathrm{H}}\ \widetilde{\widetilde{W}}_x^{\varepsilon^j}|(\alpha^j, \tau_1{}^j, \tau_2{}^j, \tau_3{}^j)$.

Connaissant $\Pi_1$ et $\Pi_2$, on déduit de l'équation (33), à une matrice de permutation près, les matrices unitaires $U_1$, $U_2$ et $U$ en effectuant :

$$U_1 = T_1 \Pi_1 \;\;, \;\; U_2 = T_2 \Pi_2 \quad \text{et} \quad U = [\, U_1 \; U_2 \,] \qquad (40)$$

On peut déduire des équations (9) et (29) la matrice $A_Q$ à une matrice diagonale et de permutation près, tel que :

$$T^{\#} U = [\boldsymbol{b}_1 \dots \boldsymbol{b}_P] = E_x \, \Lambda_x^{1/2} \;\; = A_Q \, (\varepsilon \, C_s)^{1/2} \, \Lambda \, \Pi \qquad (41)$$

où $T^{\#}$ est la pseudo-inverse de la matrice $T$. Chaque colonne , $\boldsymbol{b}_l$ $(1 \leq l \leq P)$, de la matrice $T^{\#} U$ est associé à un vecteur $\mu_q \, |c_q|^{1/2} (\boldsymbol{a}_q \otimes_q{}^*)$, $1 \leq q \leq P$, où $\mu_q$ est un scalaire complexe tel que $|\mu_q| = 1$. En conséquence, en transformant chaque colonne $\boldsymbol{b}_l$ de la matrice $T^{\#} U$ en une matrice $B_l$ de dimension $(N \mathbf{x} N)$ tel que $B_l[i,j] = \boldsymbol{b}_l((i-1)N+j)$ $(1 \leq i, j \leq N)$ on en déduit que:

$$B_l = \mu_q \, |c_q|^{1/2} \, \boldsymbol{a}_q \, \boldsymbol{a}_q{}^{\mathrm{H}} \;\; \text{pour} \;\; (1 \leq l , q \leq P) \qquad (42)$$

Dans ce contexte le vecteur directeur $\boldsymbol{a}_q$ de la $q^{\text{ième}}$ source est associé au vecteur propre de $B_l$ associé à la plus forte valeur propre.

## Récapitulation de la première version du procédé cyclique

En résumé, les étapes de la 1$^{\text{ière}}$ version du procédé cyclique sont résumées ci-dessous et sont appliquées sur $L$ observations $\boldsymbol{x}(lT_e)$ $(1 \leq l \leq L)$ des signaux reçus sur les capteurs ( $T_e$: période d'échantillonnage).

## Estimation

Etape-1: Estimation des matrices $Q_x$ et $\tilde{Q}_x$ à partir des $L$ observations $\boldsymbol{x}(lT_e)$. L'estimation de ces matrices va dépendre des hypothèses suivantes :

- *Cas stationnaire et centrés* : Estimateur empirique utilisé dans la référence [3].
- *Cas cyclo-stationnaire et centrés* : Estimateur mis en oeuvre dans la référence [10].
- *Cas cyclo-stationnaire et non-centrés* : Estimateur mis en oeuvre dans la référence [11].

## Balnchiment

Etape-2 : Décomposition en éléments propres des estimées des matrices $Q_x$ et $\tilde{Q}_x$. A partir de ces décompositions, estimation du nombre de sources $P$ et utilisation des $P$ valeurs propres principales tel que :
$Q_x \approx E_x \, \Lambda_x \, E_x{}^{\mathrm{H}}$ et $\tilde{Q}_x = \tilde{E}_x \tilde{\Lambda}_x \tilde{E}_x{}^{\mathrm{H}}$ où $\Lambda_x$ et $\tilde{\Lambda}_x$ sont des matrices diagonales contenant les $P$ valeurs propres de plus fort module et $E_x$ et $\tilde{E}_x$ sont les matrices contenant les vecteurs propres associés.
Etape-3 : Construction des matrices de blanchiment : $T = (\Lambda_x)^{-1/2} E_x{}^{\mathrm{H}}$ et $\tilde{T} = (\tilde{\Lambda}_x)^{-1/2} \tilde{E}_x{}^{\mathrm{H}}$
Etape-4 : Sélection des paramètres cycliques $(\alpha, \tau_1, \tau_2, \tau_3, \varepsilon)$ et estimation de la matrice $Q_x{}^{\varepsilon}(\alpha, \tau_1, \tau_2, \tau_3)$ à partir des $L$ observations $\boldsymbol{x}(lT_e)$. L'estimation de cette matrice va dépendre des hypothèses suivantes sur les signaux :

- *Cas stationnaire et centrés* : Estimateur empirique utilisé dans la référence [3].
- *Cas cyclo-stationnaire et centrés* : Estimateur mis en oeuvre dans la référence [10].
- *Cas cyclo-stationnaire et non-centrés* : Estimateur mis en oeuvre dans la référence [11].

**Etape-5 :** Calcul d'une matrice $W_x^\varepsilon(\alpha,\tau_1,\tau_2,\tau_3)$ de (30) à partir des matrices $Q_x^\varepsilon(\alpha,\tau_1,\tau_2,\tau_3)$, $T$ et $\tilde{T}$. Après une décomposition en valeurs singulières de $W_x^\varepsilon(\alpha,\tau_1,\tau_2,\tau_3)$, détermination des matrices unitaires $T_1$ et $\tilde{T}_1$ associé aux valeurs singulières non nulles et $T_2$ et $\tilde{T}_2$ associé aux valeurs singulières nulles.

**Sélection**

**Etape-6 :** Sélection de $K$ triplets de retards $(\tau_1^k,\tau_2^k,\tau_3^k)$ où $|\tau_1^k|+|\tau_2^k|+|\tau_3^k|\neq 0$.

**Estimation**

**Etape-7:** Estimation des $K$ matrices $Q_x(\tau_1^k,\tau_2^k,\tau_3^k)$ de (2). Comme dans l'étape-1 cette estimation va dépendre des hypothèses faite sur le signal tel que :

- *Cas stationnaire et centrés* : Estimateur empirique utilisé dans [3].
- *Cas cyclo-stationnaire et centrés* : Estimateur mis en oeuvre dans [10].
- *Cas cyclo-stationnaire et non-centrés* : Estimateur mis en oeuvre dans [11].

**Identification**

**Etape-8 :** Calcul des matrices $T_1 Q_x(\tau_1^k,\tau_2^k,\tau_3^k) T_1^H$ et estimation de la matrice unitaire $U_1$ (associé aux paramètres cycliques $(\alpha,\tau_1,\tau_2,\tau_3,\varepsilon)$) en effectuant la diagonalisation conjointe des $K$ matrices :

$$T_1\ Q_x(\tau_1{}^k,\tau_2{}^k,\tau_3{}^k)\ T_1{}^H.$$

**Etape-9 :** Calcul des matrices $T_2 Q_x(\tau_1^k,\tau_2^k,\tau_3^k) T_2^H$ et estimation de la matrice unitaire $U_2$ (associé aux autres sources) en effectuant la diagonalisation conjointe des $K$ matrices $T_2 Q_x(\tau_1^k,\tau_2^k,\tau_3^k) T_2^H$.

**Etape-10 :** Calcul de la matrice unitaire $U$ en effectuant : $U = [U_1 U_2]$

**Etape-11:** Calcul de $T^\# U = [b_1...b_P]$ et construction des matrices $B_l$ de dimension ($N$ **x** $N$) à partir des colonnes $b_l$ de $T^\# U$.

**Etape-12:** Estimation des signatures $a_q$ $(1 \leq q \leq P)$ des $P$ sources en appliquant une décomposition en élément sur chaque matrice $B_l$.

**Récapitulation de la deuxième version du procédé cyclique**

Les étapes de la 2$^{\text{ième}}$ version de la méthode FOBIUM cyclique sont résumées ci-dessous et sont appliquées sur $L$ observations $x(lT_e)$ $(1 \leq l \leq L)$ des signaux reçus sur les capteurs ( $T_e$: période d'échantillonnage).

**Etape-1:** Estimation des estimées des matrices $Q_x$ et $\tilde{Q}_x$ à partir des $L$ observations $x(lT_e)$. L'estimation de ces matrices va dépendre des hypothèses suivantes :

- *Cas stationnaire et centrés* : Estimateur empirique utilisé dans [3].
- *Cas cyclo-stationnaire et centrés* : Estimateur mis en oeuvre dans [10].
- Cas *cyclo-stationnaire et non-centrés* : Estimateur mis en oeuvre dans [11].

**Etape-2:** Décomposition en éléments propres des matrices $Q_x$ et $\tilde{Q}_x$. A partir de ces décompositions, estimation du nombre de sources $P$ et utilisation des $P$ valeurs propres principales tel que : $Q_x \approx E_x \Lambda_x E_x^H$ et $\tilde{Q}_x = \tilde{E}_x \tilde{\Lambda}_x \tilde{E}_x^H$ où $\Lambda_x$ et $\tilde{\Lambda}_x$ sont des matrices diagonales contenant les $P$ valeurs propres de plus fort module et $E_x$ et $\tilde{E}_x$ sont les matrices contenant les vecteurs propres associés.

**Etape-3:** Construction des matrices de blanchiment : $T = (\Lambda_x)^{-\frac{1}{2}} E_x^H$ et $\tilde{T} = (\tilde{\Lambda}_x)^{-\frac{1}{2}} \tilde{E}_x^H$

**Etape-4:** Sélection des paramètres cycliques $(\alpha,\tau_1,\tau_2,\tau_3,\varepsilon)$ et estimation de la matrice $Q_x^\varepsilon(\alpha,\tau_1,\tau_2,\tau_3)$ à partir des $L$ observations $x(lT_e)$. L'estimation de cette matrice va dépendre des hypothèses suivantes sur les signaux :

- *Cas stationnaire et centrés* : Estimateur empirique utilisé dans [3].
- *Cas cyclo-stationnaire et centrés* : Estimateur mis en oeuvre dans [10].
- *Cas cyclo-stationnaire et non-centrés* : Estimateur mis en oeuvre dans [11].

**Etape-5:** Calcul d'une matrice $W_x^\varepsilon(\alpha,\tau_1,\tau_2,\tau_3)$ de (30) à partir des matrices $Q_x^\varepsilon(\alpha,\tau_1,\tau_2,\tau_3)$, $T$ et $\tilde{T}$. Après une décomposition en valeurs singulières de $W_x^\varepsilon(\alpha,\tau_1,\tau_2,\tau_3)$, détermination des matrices unitaires $T_1$ et $\tilde{T}_1$ associé aux valeurs singulières non nulles et $T_2$ et $\tilde{T}_2$ associé aux valeurs singulières nulles.

**Etape-6:** Sélection de $K$ ensembles de paramètres $(\alpha^k,\tau_1^k,\tau_2^k,\tau_3^k,\varepsilon^k)$.

**Etape-7:** Estimation des $K$ matrices $Q_x^{\varepsilon k}(\alpha^k,\tau_1^k,\tau_2^k,\tau_3^k)$ de (19). Comme dans l'étape-1 cette estimation va dépendre des hypothèses faite sur le signal tel que :

- *Cas stationnaire et centrés* : Estimateur empirique utilisé dans [3].
- *Cas cyclo-stationnaire et centrés* : Estimateur mis en oeuvre dans [10].
- *Cas cyclo-stationnaire et non-centrés* : Estimateur mis en oeuvre dans [11].

**Etape-8 :** Calcul des matrices $T_1\,Q_x^{\varepsilon k}(\alpha^k,\tau_1^k,\tau_2^k,\tau_3^k)\,T_1^H$ et estimation de la matrice unitaire $U_1$ ou $\tilde{U}_1$ (associé aux paramètres cycliques (a, $\tau_1,\tau_2,\tau_3,\varepsilon$)) en effectuant la SVD conjointe des $K$ matrices : $T_1\,Q_x^{\varepsilon k}(\alpha^k,\tau_1^k,\tau_2^k,\tau_3^k)\,T_1^H$.

**Etape-9 :** Calcul des matrices $T_2\,Q_x^{\varepsilon k}(\alpha^k,\tau_1^k,\tau_2^k,\tau_3^k)\,T_2^H$ et estimation de la matrice unitaire $U_2$ ou $\tilde{U}_2$ (associé aux paramètres cycliques ($\alpha$, $\tau_1,\tau_2,\tau_3,\varepsilon$)) en effectuant la SVD conjointe des $K$ matrices : $T_2\,Q_x^{\varepsilon k}(\alpha^k,\tau_1^k,\tau_2^k,\tau_3^k)\,T_2^H$.

**Etape-10 :** Calcul de la matrice unitaire $U$ en effectuant : $U = [U_1 U_2]$

**Etape-11:** Calcul de $T^\#U = [b_1...b_P]$ et construction des matrices $B_l$ de dimension ($N$ **x** $N$) à partir des colonnes $b_l$ de $T^\#U$.

**Etape-12:** Estimation des signatures $a_q$ ($1 \leq q \leq P$) des $P$ sources en appliquant une décomposition en élément sur chaque matrice $B_l$.

**Bibliographie**

[1] A. Belouchrani, K. Abed - Meraim, J.F. Cardoso, E. Moulines, "A blind source separation technique using second-order statistics", IEEE Trans. Sig. Proc., Vol.45, N°2, pp. 434-444, Feb. 1997.

[2] JF. Cardoso, "Super-symmetric decomposition of the fourth order cumulant tensor", ICASSP 1991.

[3] J.F. Cardoso, A. Souloumiac, "Blind beamforming for non-gaussian signals", IEE Proceedings-F, Vol. 140, N°6, pp. 362-370, Dec. 1993.

[4] P.Chevalier, G.Benoit, A.Ferréol « Direction finding after blind identification of sources steering vectors: The blind-maxcor and blind-MUSIC methods», EUSIPCO , Trieste , pp 2097-2100 , 1996

[5] P. Chevalier, "Optimal separation of independent narrow-band sources : concept and performance", Sig. Proc., Elsevier, Vol. 73, pp 27-47, 1999.

[6] P. Chevalier, A.Ferréol , "On the virtual array concept for the fourth-order direction finding problem", IEEE trans on signal processing, Vol.47, N°9, pp. 2592-2595, Sept. 1999.

[7] P. Comon, "Independent component analysis - a new concept ?", Sig. Proc., Elsevier, Vol.36, N°3, Ap. 1994.

[8] P. Comon "Blind channel identification and extraction of more sources than sensors", SPIE Conf Adv Proc VIII, San Diego, July 1998.

[9] L. De Lathauwer, B. De Moor , J.Vandewalle , "ICA techniques for more sources than sensors", Proc IEEE Processing Workshop on Higher Order Statistics, Caesarea, Israel , June 1999.

[10] A. Ferréol, P. Chevalier, "On the behavior of current second and higher order blind source séparation methods for cyclostationary sources", IEEE Trans. Sig. Proc., Vol.48, N°6, pp. 1712-1725, June 2000.

[11] A. Ferréol, P. Chevalier, L. Albera " Higher order blind separation of non zero-mean cyclostationnary sources ", (EUSPICO 2002), Toulouse, Sept. 2002.

[12] A. Ferréol, P. Chevalier, L. Albera " Procédé de traitement d'antennes sur des signaux cyclostationnaires non centrés ", Brevet de Mai. 2002.

[13] A. Ferréol, P. Chevalier "Higher order blind source separation using the cyclostationarity property of the signals ", ICASSP Munich, Vol 5, pp4061-4064, 1997

[14] A. Ferréol, P. Chevalier "Higher order blind source separation using the cyclostationarity property of the signals ", ICASSP Munich, Vol 5, pp4061-4064, 1997

[10] A. Taleb "An algorithm for the blind identification of N independent signal with 2 sensors", 16th symposium on signal processing and its applications (ISSPA 2001), Kuala-Lumpur, Aug. 2001.

## Revendications

1. Procédé d'identification autodidacte à l'ordre 4 de signatures d'au moins deux sources mis en oeuvre dans un système comportant un nombre de sources P et un nombre N de capteurs de réception recevant les observations, lesdites sources ayant des tri-spectres différents et des kurtosis non nuls et de même signe **caractérisé en ce qu'**il comporte au moins les étapes suivantes :

   a) une étape de blanchiment à l'ordre 4 des observations reçues sur les capteurs de réception afin d'orthonormaliser les vecteurs directeurs des sources dans les matrices de quadricovariance des observations exploitées,
   b) une étape de diagonalisation conjointe de plusieurs matrices de quadricovariance blanchies (étape a) afin d'identifier les signatures spatiales des sources.

2. Procédé selon la revendication 1 **caractérisé en ce que** les observations utilisées correspondent aux matrices de quadricovariance moyennées temporellement définies par

$$Q_x(\tau_1, \tau_2, \tau_3) \quad \doteq \sum_{p=1}^{P} c_p(\tau_1, \tau_2, \tau_3) \, (a_p \otimes a_p{}^*) \cdot (a_p \otimes a_p{}^*)^{\mathrm{H}} \qquad (4a)$$

$$= \; A_Q \; C_s(\tau_1, \tau_2, \tau_3) \; A_Q{}^{\mathrm{H}} \qquad\qquad (4b)$$

où $A_Q$ est une matrice de dimension ($N^2$ x $P$) définie par $A_Q = [(a_1 \otimes a_1{}^*), ...., (a_p \otimes a_p{}^*)]$, $C_s(\tau_1, \tau_2, \tau_3)$ est une matrice diagonale de dimension ($P$ x $P$) définie par $C_s(\tau_1, \tau_2, \tau_3) = \mathrm{diag}[c_1(\tau_1, \tau_2, \tau_3), ..., c_p(\tau_1, \tau_2, \tau_3)]$ et où $C_p(\tau_1, \tau_2, \tau_3)$ est défini par :

$$c_p(\tau_1, \tau_2, \tau_3) = <\mathrm{Cum}(s_p(t), s_p(t\text{-}\tau_1)^*, s_p(t\text{-}\tau_2)^*, s_p(t\text{-}\tau_3))> \qquad (5)$$

3. Procédé selon la revendication 2 **caractérisé en ce qu'**il comporte au moins les étapes suivantes
   **Etape 1 :** estimer, par $\hat{Q}_x$, la matrice $Q_x$, à partir des $L$ observations $x(lT_e)$ en utilisant un estimateur non biaisé et asymptotiquement consistant.
   **Etape 2 :** décomposer en éléments propres $\hat{Q}_x$, estimer le nombre de sources $P$ et restreindre la décomposition en éléments propres aux $P$ composantes principales : $\hat{Q}_x \approx \hat{E}_x \, \hat{\Lambda}_x \, \hat{E}_x{}^{\mathrm{H}}$, où $\hat{\Lambda}_x$ est la matrice diagonale contenant les P valeurs propres de plus fort module et $\hat{E}_x$ est la matrice contenant les vecteurs propres associés.
   **Etape 3 :** construire la matrice de blanchiment : $\hat{T} = (\hat{\Lambda}_x)^{-1/2} \hat{E}_x{}^{\mathrm{H}}$.
   **Etape 4 :** sélectionner $K$ triplets de retards $(\tau_1{}^k, \tau_2{}^k, \tau_3{}^k)$ où $|\tau_1{}^k| + |\tau_2{}^k| + |\tau_3{}^k| \neq 0$.
   **Etape 5 :** estimer , par $\hat{Q}_x(\tau_1{}^k, \tau_2{}^k, \tau_3{}^k)$, les $K$ matrices $Q_x(\tau_1{}^k, \tau_2{}^k, \tau_3{}^k)$.
   **Etape 6 :** calculer les matrices $\hat{T} \, \hat{Q}_x(\tau_1{}^k, \tau_2{}^k, \tau_3{}^k) \, \hat{T}^{\mathrm{H}}$ et estimer, $\hat{U}_{sol}$, la matrice unitaire $U_{sol}$ par diagonalisation conjointe des K matrices $\hat{T} \, \hat{Q}_x(\tau_1{}^k, \tau_2{}^k, \tau_3{}^k) \, \hat{T}^{\mathrm{H}}$
   **Etape 7 :** calculer $\hat{T}^{\#} \hat{U}_{sol} = [b_1 ... b_P]$ et construire des matrices $\hat{B}_l$ de dimension ($N$ x $N$).
   **Etape 8:** estimer, par $\hat{a}_p$, les signatures $a_q$ ($1 \leq q \leq P$) des $P$ sources en appliquant une décomposition en élément

sur chaque matrice $\hat{B}_L$.

**4.** Procédé selon l'une des revendications 1 à 3 **caractérisé en ce qu'**il comporte au moins une étape d'évaluation de la qualité de l'identification du vecteur directeur associé en utilisant un critère tel que

$$D(A, \hat{A}) \ = \ (\alpha_1, \alpha_2, \ldots, \alpha_P) \qquad\qquad (16)$$

où

$$\alpha_P \ = \ \min_{1 \le i \le P} [d(\boldsymbol{a}_P, \hat{\boldsymbol{a}}_i)] \qquad\qquad (17)$$

et où $d(\boldsymbol{u},\boldsymbol{v})$ est la pseudo-distance entre les vecteurs $\boldsymbol{u}$ et $\boldsymbol{v}$, tel que :

$$d(\boldsymbol{u}, \boldsymbol{v}) \ = \ 1 \ - \ \frac{\left|\boldsymbol{u}^H \boldsymbol{v}\right|^2}{\left(\boldsymbol{u}^H \boldsymbol{u}\right)\left(\boldsymbol{v}^H \boldsymbol{v}\right)} \qquad\qquad (18)$$

**5.** Procédé selon l'une des revendications 1 à 3 **caractérisé en ce qu'**il comporte au moins une étape d'isolation cyclique à l'ordre 4 après l'étape a) de blanchiment à l'ordre 4.

**6.** Procédé selon la revendication 5 **caractérisé en ce que** l'étape d'identification est réalisée en utilisant des statistiques cycliques d'ordre 4.

**7.** Procédé selon l'une des revendications 1 à 6 **caractérisé en ce que** le nombre de sources P est supérieur ou égal au nombre de capteurs.

**8.** Procédé selon l'une des revendications 1 à 7 **caractérisé en ce qu'**il comporte au moins une étape de goniométrie à partir de la signature identifiée des sources.

**9.** Procédé selon l'une des revendications 1 à 7 **caractérisé en ce qu'**il comporte au moins une étape de filtrage spatial après la signature identifiée des sources.

**10.** Utilisation du procédé selon l'une des revendications 1 à 9 à un réseau de communication.

**Claims**

**1.** Self-taught 4-order, for identifying signatures of at least two sources in a system including a number of sources P and a number N of reception sensors receiving observations, the said sources having different tri-spectra and non-zero kurtoses of like sign, **characterized in that** it comprises at least the following steps:

a) fourth-order whitening of the observations received on the reception sensors in order to orthonormalize the direction vectors of the sources in matrices of quadricovariance of the observations used,
b) joint diagonalizing of several whitened matrices of quadricovariance (step a) to identify the spatial signatures of the sources.

**2.** Method according to Claim 1, **characterized in that** the observations used correspond to time-domain averaged matrices of quadricovariance defined by:

$$Q_x(\tau_1,\tau_2,\tau_3) \quad = \sum_{p=1}^{P} c_p(\tau_1,\tau_2,\tau_3)\,(a_p \otimes a_p^*)\,(a_p \otimes a_p^*)^H \tag{4a}$$

$$= A_Q\, C_s(\tau_1,\tau_2,\tau_3)\, A_Q{}^H \tag{4b}$$

where $A_Q$ is a matrix with a dimension ($N^2 \times P$) defined by $A_Q = [(a_1 \otimes a_1^*), ..., (a_p \otimes a_p^*)]$, $C_s(\tau_1,\tau_2,\tau_3)$ is a diagonal matrix with a dimension ($P \times P$) defined by $C_s(\tau_1,\tau_2,\tau_3) = \text{diag}[C_1(\tau_1,\tau_2,\tau_3), ..., Cp(\tau_1,\tau_2,\tau_3)]$ and where $C_p(\tau_1,\tau_2,\tau_3)$ is defined by:

$$c_p(\tau_1,\tau_2,\tau_3) = \langle \text{Cum}(s_p(t),\, s_p(t-\tau_1)^*,\, s_p(t-\tau_2)^*,\, s_p(t-\tau_3)) \rangle. \tag{5}$$

3. Method according to Claim 2, **characterized in that** it comprises at least the following steps:

   **Step 1:** estimating, through $\hat{Q}_x$, of the matrix $Q_x$, from the L observations $x(lT_e)$ using a non-biased and asymptotically consistent estimator
   **Step 2:** the eigen-element decomposition of $\hat{Q}_x$, the estimation of the number of sources P and the limiting of the eigen-element decomposition to the P main components: $\hat{Q}_x \approx \hat{E}_x \hat{\Lambda}_x \hat{E}_x^H$, where $\hat{\Lambda}_x$ is the diagonal matrix containing the P eigenvalues with the highest modulus and $\hat{E}_x$ is the matrix containing the associated eigenvectors
   **Step 3:** building of the whitening matrix: $\hat{T} = (\hat{\Lambda}_x)^{-1/2} \hat{E}_x^H$
   **Step 4:** selecting K triplets of delays ($\tau_1{}^k,\tau_2{}^k,\tau_3{}^k$), where $|\tau_1{}^k| + |\tau_2{}^k| + |\tau_3{}^k| \neq 0$
   **Step 5:** estimating, through $\hat{Q}_x(\tau_1{}^k,\tau_2{}^k,\tau_3{}^k)$, of K matrices $Q_x(\tau_1{}^k,\tau_2{}^k,\tau_3{}^k)$
   **Step 6:** computing of the matrices $\hat{T}_x\, Q_x(\tau_1{}^k,\tau_2{}^k,\tau_3{}^k)\, \hat{T}^H$ and the estimation, by $\hat{U}_{sol}$, of the unitary matrix $U_{sol}$ by the joint diagonalizing of the K matrices $\hat{T}\, Q_x(\tau_1{}^k,\tau_2{}^k,\tau_3{}^k)\, \hat{T}^H$
   **Step 7:** computing $\hat{T}^\#\hat{U}_{sol} = \lfloor \hat{b}_1 \cdots \hat{b}_P \rfloor$ and the construction of the matrices $\hat{B}_l$ sized ($N \times N$)
   **Step 8:** estimating, through $\hat{a}_q$, of the signatures $a_q$ ($1 \leq q \leq P$) of the P sources by applying a decomposition into elements on each matrix $\hat{B}_l$.

4. Method according to one of Claims 1 to 3, **characterized in that** it comprises at least one step of evaluating the quality of identification of the associated direction vector by using a criterion such that

$$D(A, \hat{A}) = (\alpha_1, \alpha_2, \ldots, \alpha_P) \tag{16}$$

where

$$\alpha_p = \min_{1 \leq i \leq P}\,[d(a_p, \hat{a}_i)] \tag{17}$$

and where d(u,v) is the pseudo-distance between the vectors u and v, such that:

$$d(u, v) = 1 - \frac{|u^H v|^2}{(u^H u)(v^H v)} \tag{18}$$

**5.** Method according to one of Claims 1 to 3, **characterized in that** it comprises at least one step of 4-order cyclic isolation after the step a) of fourth-order whitening.

**6.** Method according to Claim 5, **characterized in that** the identification step is performed by using fourth-order cyclical statistics.

**7.** Method according to one of Claims 1 to 6, **characterized in that** the number of sources P is greater than or equal to the number of sensors.

**8.** Method according to one of Claims 1 to 7, **characterized in that** it comprises at least one goniometry step using the identified signature of the sources.

**9.** Method according to one of Claims 1 to 7, **characterized in that** it comprises at least one spatial filtering step after the identified signature of the sources.

**10.** Use of the method according to one of Claims 1 to 9 in a communications network.

**Patentansprüche**

**1.** Autodidaktisches Verfahren der Ordnung 4 zur Identifikation von Signaturen von mindestens zwei Quellen in einem System, das eine Anzahl P von Quellen und eine Anzahl N von Empfangssensoren aufweist, die die Beobachtungen empfangen, wobei die Quellen unterschiedliche Trispektren und Kurtosis ungleich Null und mit dem gleichen Vorzeichen haben, **dadurch gekennzeichnet, dass** es mindestens die folgenden Schritte aufweist:

   a) einen Whitening-Schritt der Ordnung 4 der in den Empfangssensoren empfangenen Beobachtungen, um die Richtvektoren der Quellen in den Quadrikovarianzmatrizen der ausgewerteten Beobachtungen zu orthonormalisieren,
   b) einen Schritt der gemeinsamen Diagonalisierung mehrerer Whitened-Quadrikovarianzmatrizen (Schritt a), um die räumlichen Signaturen der Quellen zu identifizieren.

**2.** Verfahren nach Anspruch 1, **dadurch gekennzeichnet, dass** die verwendeten Beobachtungen den zeitlich gemittelten Quadrikovarianzmatrizen entsprechen, die definiert sind durch

$$Q_x(\tau_1,\tau_2,\tau_3) = \sum_{p=1}^{P} c_p(\tau_1,\tau_2,\tau_3)\,(a_p \otimes a_p^*)\,(a_p \otimes a_p^*)^H \tag{4a}$$

$$= A_Q\,C_s(\tau_1,\tau_2,\tau_3)\,A_Q^{\ H} \tag{4b}$$

wobei $A_Q$ eine Matrix der Dimension $(N^2 \times P)$ definiert durch $A_Q = [(\alpha_1 \otimes \alpha_1^*), ..., (\alpha_p \otimes \alpha_p^*)]$ ist, $C_s(\tau_1,\tau_2,\tau_3)$ eine diagonale Matrix der Dimension $(P \times P)$ definiert durch $C_s(\tau_1,\tau_2,\tau_3)=\mathrm{diag}[c_1(\tau_1,\tau_2,\tau_3), ..., c_p(\tau_1,\tau_2,\tau_3)]$ ist, und wobei $c_p(\tau_1,\tau_2,\tau_3)$ definiert wird durch:

$$c_p(\tau_1,\tau_2,\tau_3) = \langle \mathrm{Cum}(s_p(t), s_p(t-\tau_1)^*, s_p(t-\tau_2)^*, s_p(t-\tau_3)) \rangle \tag{5}$$

**3.** Verfahren nach Anspruch 2, **dadurch gekennzeichnet, dass** es mindestens die folgenden Schritte aufweist Schritt 1: Schätzen, durch $\hat{Q}_x$, der Matrix $Q_x$, ausgehend von den L Beobachtungen $x(lT_e)$ unter Verwendung einer nicht verzerrten und asymptotisch konsistenten Schätzfunktion.

Schritt 2: Zerlegen in Eigenelemente $\hat{Q}_x$, Schätzen der Anzahl von Quellen P und Beschränken der Zerlegung in Eigenelemente auf die P Hauptkomponenten: $\hat{Q}_x \approx \hat{E}_x \hat{\Lambda}_x \hat{E}_x^H$, wobei $\hat{\Lambda}_x$ die diagonale Matrix ist, die die P Eigenwerte mit stärkstem Modul enthält, und $\hat{E}_x$ die Matrix ist, die die zugeordneten Eigenvektoren enthält.

Schritt 3: Konstruieren der Whitening-Matrix: $\hat{T} = (\hat{\Lambda}_x)^{-1/2}\hat{E}_x^H$.

Schritt 4: Wählen von K Verzögerungs-Tripletts $(\tau_1^k, \tau_2^k, \tau_3^k)$, wobei gilt $|\tau_1^k|+|\tau_2^k|+|\tau_3^k| \neq 0$.

Schritt 5: Schätzen, durch $\hat{Q}_x(\tau_1^k, \tau_2^k, \tau_3^k)$, der K Matrizen $Q_x(\tau_1^k, \tau_2^k, \tau_3^k)$.

Schritt 6: Berechnen der Matrizen $\hat{T} \hat{Q}_x(\tau_1^k, \tau_2^k, \tau_3^k)\hat{T}^H$ und Schätzen, $\hat{U}_{sol}$, der Einzelmatrix $U_{sol}$ durch gemeinsame Diagonalisierung der K Matrizen $\hat{T} \hat{Q}_x(\tau_1^k, \tau_2^k, \tau_3^k)\hat{T}^H$

Schritt 7: Berechnen von $\hat{T}^{\#}\hat{U}_{sol} = (b_1...b_P)$ und Konstruieren der Matrizen $\hat{B}_l$ der Dimension (NxN). Schritt 8: Schätzen, durch $\hat{\alpha}_p$, der Signaturen $\alpha_q(1 \leq q \leq P)$ der P Quellen unter Anwendung einer Elementzerlegung in jeder Matrix $\hat{B}_l$.

4. Verfahren nach einem der Ansprüche 1 bis 3, **dadurch gekennzeichnet, dass** es mindestens einen Schritt der Bewertung der Qualität der Identifikation des zugeordneten Richtvektors unter Verwendung eines Kriteriums wie folgt aufweist

$$D(A, \ \hat{A}) \ = \ (\alpha_1, \ \alpha_2, \ ..., \ \alpha_P) \qquad (16)$$

wobei gilt

$$\alpha_P \ = \ \min_{1 \leq i \leq P} [d(\alpha_P, \hat{\alpha}_i)] \qquad (17)$$

und wobei $d(u,v)$ der Pseudo-Abstand zwischen den Vektoren $u$ und $v$ ist, derart, dass gilt:

$$d(u, \ v) \ = \ 1 \ - \ \frac{\left|u^H v\right|^2}{\left(u^H u\right)\left(v^H v\right)} \qquad (18)$$

5. Verfahren nach einem der Ansprüche 1 bis 3, **dadurch gekennzeichnet, dass** es mindestens einen Schritt der zyklischen Isolierung der Ordnung 4 nach dem Schritte a) des Whitening der Ordnung 4 aufweist.

6. Verfahren nach Anspruch 5, **dadurch gekennzeichnet, dass** der Schritt der Identifikation unter Verwendung der zyklischen Statistiken der Ordnung 4 durchgeführt wird.

7. Verfahren nach einem der Ansprüche 1 bis 6, **dadurch gekennzeichnet, dass** die Anzahl von Quellen P größer als oder gleich der Anzahl von Sensoren ist.

8. Verfahren nach einem der Ansprüche 1 bis 7, **dadurch gekennzeichnet, dass** es mindestens einen Schritt der Goniometrie ausgehend von der identifizierten Signatur der Quellen aufweist.

9. Verfahren nach einem der Ansprüche 1 bis 7, **dadurch gekennzeichnet, dass** es mindestens einen Schritt des räumlichen Filterns nach der identifizierten Signatur der Quellen aufweist.

10. Verwendung des Verfahrens nach einem der Ansprüche 1 bis 9 bei einem Kommunikationsnetzwerk.

**FIG.1**

**FIG.2**

**FIG.3**

**FIG.4**

**FIG.5**

**FIG.6**

EP 1 465 338 B1

$(\tau_1{}^i, \tau_2{}^i, \tau_3{}^i)$
pour $1 \leq i \leq K^\alpha$

*Sources en*
$(\alpha, \tau_1, \tau_2, \tau_3)$

**Identification**
avec les statistiques
d'ordre 4

$a_p$
*pour*
$1 \leq p \leq P_1$

**Blanchiment**
à l'ordre 4

**Isolation**
**cyclique**
**l'ordre 4**

$x(t)$

**Identification**
avec les statistiques
d'ordre 4

$a_p$
*pour*
$P_1 + 1 \leq p \leq P$

$(\alpha, \tau_1, \tau_2, \tau_3)$

*Les autres*
*sources*

$(\tau_1{}^j, \tau_2{}^j, \tau_3{}^j)$
pour $1 \leq j \leq K$

*Réseau*
*d'antennes*

## FIG.7

FIG.8

Réseau
d'antennes

$x(t)$

**Blanchiment
à l'ordre 4**

**Isolation
cyclique
à l'ordre 4**

$(\alpha^l, \tau_1^l, \tau_2^l, \tau_3^l)$

Sources en
$(\alpha^l, \tau_1^l, \tau_2^l, \tau_3^l)$

**Identification**
avec les statistiques
cycliques/classiques
d'ordre 4

$a_p^{\Gamma}$

**Identification**
avec les statistiques
cycliques/classiques
d'ordre 4

**Isolation
cyclique
à l'ordre 4**

$(\alpha^l, \tau_1^l, \tau_2^l, \tau_3^l)$

Sources en
$(\alpha^l, \tau_1^l, \tau_2^l, \tau_3^l)$

**Identification**
avec les statistiques
cycliques/classiques
d'ordre 4

**Identification**
avec les statistiques
cycliques/classiques
d'ordre 4

$a_p^l$

# FIG.9

**EP 1 465 338 B1**

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Littérature non-brevet citée dans la description**

- **A. BELOUCHRANI ; K. ABED - MERAIM ; J.F. CARDOSO ; E. MOULINES.** A blind source separation technique using second-order statistics. *IEEE Trans. Sig. Proc.,* Février 1997, vol. 45 (2), 434-444
- **JF. CARDOSO.** Super-symmetric decomposition of the fourth order cumulant tensor. *ICASSP 1991.*
- **J.F. CARDOSO ; A. SOULOUMIAC.** Blind beamforming for non-gaussian signals. *IEE Proceedings-F,* Décembre 1993, vol. 140 (6), 362-370
- **P.CHEVALIER ; G.BENOIT ; A.FERRÉOL.** *EUSIPCO,* 1996, 2097-2100
- Optimal separation of independent narrow-band sources : concept and performance. **P. CHEVALIER.** Sig. Proc.,. Elsevier, 1999, vol. 73, 27-47
- **P. CHEVALIER ; A.FERRÉOL.** On the virtual array concept for the fourth-order direction finding problem. *IEEE trans on signal processing,* Septembre 1999, vol. 47 (9), 2592-2595
- Independent component analysis - a new concept ?. **P. COMON.** Sig. Proc.,. Elsevier, Avril 1994, vol. 36
- **P. COMON.** Blind channel identification and extraction of more sources than sensors. *SPIE Conf Adv Proc VIII,* Juillet 1998
- **L. DE LATHAUWER ; B. DE MOOR ; J.VANDE-WALLE.** ICA techniques for more sources than sensors. *Proc IEEE Processing Workshop on Higher Order Statistics,* Juin 1999
- **A. FERRÉOL ; P. CHEVALIER.** On the behavior of current second and higher order blind source séparation methods for cyclostationary sources. *IEEE Trans. Sig. Proc.,* Juin 2000, vol. 48 (6), 1712-1725
- **A. FERRÉOL ; P. CHEVALIER ; L. ALBERA.** Higher order blind separation of non zero-mean cyclostationnary sources. *(EUSPICO 2002,* Septembre 2002
- **A. FERRÉOL ; P. CHEVALIER ; L. ALBERA.** *Procédé de traitement d'antennes sur des signaux cyclostationnaires non centrés,* Mai 2002
- **A. FERRÉOL ; P. CHEVALIER.** Higher order blind source separation using the cyclostationarity property of the signals. *ICASSP,* 1997, vol. 5, 4061-4064
- **A. TALEB.** An algorithm for the blind identification of N independent signal with 2 sensors. *16th symposium on signal processing and its applications (ISSPA 2001),* Août 2001